# EUROPEAN PATENT SPECIFICATION

(11) **EP 2 893 549 B1**
(45) Date of publication and mention of the grant of the patent: **04.03.2020**
(21) Application number: 13777148.1
(22) Date of filing: 02.09.2013
(51) Int. Cl.: H01J 45/00, B23K 26/00, F24S 70/16, H01L 35/16, H01L 35/22, H01L 35/30, H01L 35/32, H01L 35/34, B23K 26/0622, B23K 26/352, B23K 101/34, B23K 103/00

(54) **THERMIONIC CONVERTER DEVICE**
THERMIONISCHE WANDLERVORRICHTUNG
DISPOSITIF DE CONVERTISSEUR THERMO-IONIQUE

(30) Priority: 03.09.2012 IT RM20120427
(43) Date of publication of application: 15.07.2015
(73) Proprietor: Consiglio Nazionale Delle Ricerche, 00185 Roma (IT)
(72) Inventor: TRUCCHI, Daniele Maria, I-00016 Monterotondo Scalo (RM) (IT); CAPPELLI, Emilia, I-00016 Monterotondo Scalo (RM) (IT); ORLANDO, Stefano, I-85050 Tito Scalo (PZ) (IT); SCITI, Diletta, I-48018 Faenza (RA) (IT)
(74) Representative: Scilletta, Andrea
(86) International application number: PCT/IB2013/058225
(87) International publication number: WO 2014/033690

(56) References cited:
- WO-A1-2012/114366
- US-A- 3 201 618
- US-A- 5 904 778
- US-A1- 2008 197 747
- US-A1- 2008 299 408
- US-A1- 2011 148 248
- US-A1- 2011 221 328
- Kenneth Mcenaney ET AL: "Direct Heat-To-Electricity Conversion Of Solar Energy", Annual Review of Heat Transfer, vol. 15, no. 15, 4 September 2012 (2012-09-04), pages 179-230, XP055562946, US ISSN: 1049-0787, DOI: 10.1615/AnnualRevHeatTransfer.2012004544
- JAE HYUNG LEE ET AL: "Microfabricated silicon carbide thermionic energy converter for solar electricity generation", MICRO ELECTRO MECHANICAL SYSTEMS (MEMS), 2012 IEEE 25TH INTERNATIONAL CONFERENCE ON, IEEE, 29 January 2012 (2012-01-29), pages 1261-1264, XP032137447, DOI: 10.1109/MEMSYS.2012.6170386 ISBN: 978-1-4673-0324-8

## Description

The present invention relates to a thermionic, and possibly also thermoelectric, converter device that may be advantageously integrated into solar concentrator systems (also known as CSP systems: Concentrating Solar Power), that allows in an efficient, reliable, compact, and easy to control, to convert energy from electromagnetic radiation, in particular concentrated solar energy, to electrical and possibly thermal power. The present invention further relates to the process of microfabrication of the converter device.

In the following of the present description and in the claims ceramic materials are defined with the phrase substance"-based ceramic material"; it must be understood that such phrase includes both ceramic materials comprising the substance and ceramic materials consisting of only the substance (apart from the usual chemical contamination of materials that is tolerable with the current fabrication technologies), whereby in the latter case the phrase must be intended as a synonym of "substance".

Although in the following reference is mainly made to an application of the converter device according to the invention for a CSP system, it may be applied in any other technological field of conversion of energy from electromagnetic radiation to electrical, and possibly thermal, power, still remaining within the scope of protection as defined by the attached claims. By way of example, another field of application of the converter device according to the invention could be the aerospace sector, wherein in low-pressure or near-absolute vacuum conditions, as the conditions outside the Earth's atmosphere, the converter is capable to operate in a highly efficient way.

It is known that in the last years some thermionic and thermoelectric converter devices have been developed for producing electric energy starting from solar radiation, preferably concentrated through CSP systems. By way of example, Naito H. et al., in "Development of a Solar Receiver for a High-Efficiency Thermionic/Thermoelectric Conversion", Solar Energy Vol. 58, No. 4-6, pp. 191-195, 1996 Elsevier Science Ltd., discloses a converter system combining a thermionic device with a thermoelectric one and working at very high temperature, higher than 1600 °C, wherein the thermionic emitter operates by radiation from grey body. Differently, document US2011221328A1 discloses a thermionic converter device working at much lower temperatures.

However, prior art converter devices suffer from some drawbacks.

First of all, they usually work at very high temperatures. This entails the need for very sophisticated concentrator systems for obtaining very high factors of solar radiation concentration. This entails that the converter devices and the related concentrator systems are rather complex, difficult to control, and they require a careful installation and a frequent maintenance. Moreover, prior art converter devices, most of all those working at low temperatures, are not efficient.

It is an object of this invention, therefore, to allow in a manner that is efficient, reliable, compact, and easy to control, to convert concentrated solar energy to electrical and thermal power.

The present invention defines a converter device according to claim 1 and a process of microfabrication of such a converter device according to claim 9.

It is described a converter device for converting energy from electromagnetic radiation, in particular concentrated solar energy, in electrical power, comprising un thermionic emitter separated by an inter-electrode space from a thermionic collector, the thermionic emitter and the thermionic collector being provided with electrical connection means configured to be connectable to a first external electrical load for supplying electrical power, the converter device being characterised in that it further comprises an absorber of electromagnetic radiation, configured to transform electromagnetic radiation energy to thermal energy, having an outer surface configured to be exposed to electromagnetic radiation and an inner surface integrally coupled to the thermionic emitter, the outer surface being provided with a sub-micrometer periodic surface structure, the thermionic emitter being monolithically integrated on said inner surface of the absorber, the absorber being made of a material selected from the group comprising or consisting of:
- ceramic materials selected from the group comprising or consisting of:
   hafnium carbide (HfC),
   hafnium carbide (HfC) having a volume percentage of molybdenum silicide (MoSi₂) lower than 40%,
   silicon carbide (SiC),
   silicon carbide (SiC) containing additives in a volume percentage lower than 20%,
   silicon carbide (SiC) containing additives in a volume percentage lower than 20% and further comprising molybdenum silicide in a volume percentage ranging from 20% to 40%,
   aluminium nitride (AIN)-based ceramic materials containing additives and further containing a volume percentage of silicon carbide ranging from 5% to 25% and a volume percentage of molybdenum silicide ranging from 20% to 40%,
   tantalum carbide (TaC),
   tantalum carbide (TaC)-based ceramic material,
- refractory metals selected from the group comprising or consisting of molybdenum and tungsten,
- pyrolitic graphite,
the thermionic emitter being made of a material selected from the group comprising or consisting of:
- thin film diamond of thickness lower than 25 micrometers deposited through chemical vapour deposition (CVD),
- thin film diamond of thickness lower than 25 micrometers deposited through CVD having a n-type doping,
- thin film diamond of thickness lower than 25 micrometers deposited through CVD having surface chemical termination with monoatomic hydrogen and/or depositions of zirconium and/or caesium,
- thin film diamond of thickness lower than 25 micrometers deposited through CVD having a n-type doping and having surface chemical termination with monoatomic hydrogen and/or depositions of zirconium and/or caesium,
- thin film ceramic materials of thickness lower than 25 micrometers selected from the group comprising or consisting of:
   titanium nitride (TiN)-based ceramic materials,
   molybdenum silicide-based ceramic materials,
   carbide-based ceramic materials,
   boride-based ceramic materials,
- refractory metals in thin film form with thickness not larger than 1 micrometer.

Preferably, the absorber may be made of a ceramic material selected from the group comprising or consisting of:
hafnium carbide (HfC) having a volume percentage of molybdenum silicide (MoSi₂) ranging from 2% to 30%, preferably ranging from 3% to 20%, more preferably ranging from 4% to 10%, still more preferably equal to 5%,
silicon carbide (SiC) containing additives in a volume percentage lower than 20%, the additives comprising or consisting of aluminium oxide (Al₂O₃) and yttrium oxide (Y₂O₃), wherein the aluminium oxide is preferably ranging from 3% to 9% in volume, more preferably equal to 6% in volume, and wherein the yttrium oxide is preferably ranging from 1% to 7% in volume, more preferably equal to 4% in volume,
silicon carbide (SiC) containing additives in a volume percentage lower than 20%, the additives comprising or consisting of aluminium oxide (Al₂O₃) and yttrium oxide (Y₂O₃), and further comprising molybdenum silicide in a volume percentage ranging from 20% to 40%, wherein the aluminium oxide is preferably ranging from 3% to 9% in volume, more preferably equal to 6% in volume, and wherein the yttrium oxide is preferably ranging from 1% to 7% in volume, more preferably equal to 4% in volume, and wherein the molybdenum silicide is present with a volume percentage preferably ranging from 25% to 35%, more preferably equal to 30%,
aluminium nitride (AIN)-based ceramic materials containing additives comprising or consisting of yttrium oxide with a weight percentage ranging from 1% to 5%, preferably ranging from 1% to 3%, more preferably equal to 2%, and further containing a volume percentage of silicon carbide ranging from 5% to 25%, preferably ranging from 10% to 20%, more preferably equal to 15%, and a volume percentage of molybdenum silicide ranging from 20% to 40%, preferably ranging from 25% to 35%, more preferably equal to 30%,
tantalum carbide (TaC)-based ceramic material containing additives, preferably comprising or consisting of aluminium oxide and/or yttrium oxide, and/or molybdenum silicide with a volume percentage of molybdenum silicide ranging from 20% to 40%, preferably ranging from 25% to 35%, more preferably equal to 30%.

According to a further aspect of the invention, the thermionic emitter may be made of a material selected from the group comprising or consisting of:
- thin film diamond of thickness lower than 10 micrometers, preferably lower than 5 micrometers, more preferably lower than 1 micrometer, deposited through CVD,
- thin film diamond of thickness lower than 25 micrometers, preferably lower than 10 micrometers, more preferably lower than 5 micrometers, still more preferably lower than 1 micrometer, deposited through CVD having a n-type doping with nitrogen,
- thin film diamond of thickness lower than 10 micrometers, preferably lower than 5 micrometers, more preferably lower than 1 micrometer, deposited through CVD having surface chemical termination with monoatomic hydrogen and/or depositions of zirconium and/or caesium,
- thin film diamond of thickness lower than 25 micrometers, preferably lower than 10 micrometers, more preferably lower than 5 micrometers, still more preferably lower than 1 micrometer, deposited through CVD having a n-type doping with nitrogen and having surface chemical termination with monoatomic hydrogen and/or depositions of zirconium and/or caesium,
- titanium carbide (TiC)- and/or zirconium carbide (ZrC)- and/or tungsten carbide (WC)- and/or hafnium carbide (HfC)-based thin film ceramic materials of thickness lower than 25 micrometers,
- titanium boride (TiB₂)- and/or zirconium boride (ZrB₂)- and/or lanthanum hexaboride (LaB₆)-based thin film ceramic materials of thickness lower than 25 micrometers,
- thin film ceramic materials of thickness lower than 10 micrometers, preferably lower than 5 micrometers, more preferably lower than 1 micrometer, selected from the group comprising or consisting of:
   titanium nitride (TiN)-based ceramic materials,
   molybdenum silicide-based ceramic materials,
   carbide-based ceramic materials,
   boride-based ceramic materials,
- refractory metals in thin film form with thickness not larger than 1 micrometer, preferably not larger than 800 nanometers, more preferably not larger than 700 nanometers, still more preferably not larger than 600 nanometers, even more preferably not larger than 500 nanometers, even still more preferably not larger than 400 nanometers, selected from the group comprising or consisting of molybdenum and tungsten.

According to an additional aspect of the invention, the thermionic emitter may be separated from the thermionic collector by a distance lower than 1 mm, preferably lower than 100 micrometers, more preferably lower than 10 micrometers, the thermionic emitter being preferably separated from the thermionic collector through one or more spacers more preferably made of a material selected from the group comprising or consisting of zirconia, alumina, and MACOR® glass ceramic, the thermionic collector being preferably made of a material selected from the group comprising or consisting of molybdenum and tungsten, more preferably coated with caesium. In particular, in the following of the present description and in the claims, it should be intended that glass ceramic MACOR® is the material of machinable glass ceramic, the registered trademark of which is MACOR®, available from US company Corning Inc. of Corning, NY, and approximately composed of 55 % fluorophlogopite mica and 45% borosilicate glass, as reported in the data sheet of MACOR® available on the web, e.g., at the address http://psec.uchicago.edu/ceramics/MACOR%20Data%20Sheet.pdf

According to another aspect of the invention, the absorber may be provided on one or more side walls with a layer of refractory metal, the absorber 1 having preferably a shape of a disc, more preferably having diameter ranging from 30 mm to 50 mm and thickness ranging from 3 mm to 10 mm.

According to a further aspect of the invention, the converter device may further comprise a housing case, wherein the absorber, the thermionic emitter and the thermionic collector are housed, the housing case being provided with a through hole closed by a window configured to transmit electromagnetic radiation impinging on the same window to the outer surface of the absorber, the housing case being configured to maintain vacuum conditions inside, preferably such that a pressure inside the housing case is lower than 10⁻⁵ mbar, said through hole being shaped according to a cone frustum with inner walls having an inclination with respect to a vertical axis of the cone frustum preferably equal to 45°, the converter device preferably further comprising a pumping apparatus connected through hydraulic connection means to the housing case, a distance between the window and the outer surface of the absorber being preferably ranging from 1,0 mm to 10,0 mm, more preferably equal to 5,0 mm, the converter device preferably further comprising a front active heat sink comprising at least one cavity provided with hydraulic connection means configured to receive a flow of a cooling liquid for extracting heat from the window, the cooling liquid preferably comprising a solution of deionized water and ethylene glycol, more preferably in proportion 50%-50%, or demineralized water, an inner surface of the housing case being preferably coated with a layer of infrared reflecting material.

According to an additional aspect of the invention, the converter device may further comprise a thermoelectric module comprising a first layer configured to operate as hot side of the thermoelectric module, the first layer being integrally coupled to a plurality of thermoelectric elements provided with interconnecting tracks, the plurality of thermoelectric elements being in turn integrally coupled to a second layer configured to operate as cold side of the thermoelectric module, the thermionic collector being integrally coupled to the first layer, the thermoelectric module being provided with electrical connection means configured to be connectable to a second external electrical load for supplying electrical power to the latter, the first layer and the second layer being each preferably made of a ceramic material, more preferably diamond deposited through CVD or aluminium nitride deposited through screen printing or geopolimeric coating, the thermoelectric elements being preferably selected from the group comprising semiconductor elements and pairs of elements made of metals with different work function, the thermoelectric elements being more preferably made of a material selected from the group comprising or consisting of:
- a bismuth telluride (Bi₂Te₃) and antimony telluride (Sb₂Te)-based material,
- a lead telluride (PbTe)-based material,
- a silicon germanium (SiGe) alloy-based material,
- a doped barium and strontium titanate and/or lanthanate-based material,
- a carbides and/or borides-based material,
- a silicon carbide and/or silicon-silicon carbide-based material,
- a boron carbide-titanium boride (B₄C-TiB₂)-based material,
- a metal-ceramic composite material,
the thermoelectric elements being still more preferably made of thin film lead telluride and n-type doped through antimony telluride and p-type doped through silver.

According to another aspect of the invention, the converter device may further comprise back heat sinker means integrally coupled to the second layer of the thermoelectric module and configured to extract heat from the second layer of the thermoelectric module, said heat sinker means being selected from the group consisting of:
- a back active heat sink comprising at least one cavity provided with hydraulic connection means configured to receive a flow of a cooling liquid for thermostatically controlling the second layer of the thermoelectric module, the cooling liquid preferably comprising a solution of deionized water and ethylene glycol, more preferably in proportion 50%-50%, or demineralized water,
- a passive heat exchanger.

It is described a process of microfabrication of a converter device for converting energy from electromagnetic radiation, in particular concentrated solar energy, to electrical power, characterised in that the converter device is the just described converter device, whereby the converter device comprises an absorber of electromagnetic radiation, having an outer surface configured to be exposed to electromagnetic radiation and an inner surface and provided with a sub-micrometer periodic surface structure, and a thermionic emitter and a thermionic collector, and in that the process comprises the steps of:
A. having the absorber,
B. depositing on said inner surface of the absorber the material of which the thermionic emitter is made, whereby at the end of step B the thermionic emitter is monolithically integrated on said inner surface of the absorber,
C. making the sub-micrometer periodic surface structure by means of a treatment of the outer surface of the absorber through femto-second laser, whereby a laser beam directly impinges the outer surface of the absorber.

According to another aspect of the invention, step C may be performed with:
- laser wavelength ranging from 200 to 1000 nanometers, preferably from 550 to 800 nanometers;
- duration of single laser pulse ranging from 10 to 100 femto-seconds;
- impingement of the laser beam with an angle with respect to a normal to the outer surface of the absorber ranging from 0° to 60°, preferably with impingement orthogonal to the outer surface of the absorber, i.e. with an angle with respect to the normal to the outer surface of the absorber equal to 0°;
- laser pulse energy varying within the range 0,01 - 5,00 mJ/pulse, preferably within the range 0,2 - 2,0 mJ/pulse;
- spot focusing having diameter ranging from 5 µm to 1 mm, preferably ranging from 100 µm to 0,5 mm;
- speed of a translational plate on which the absorber the outer surface of which is treated under the laser beam is mounted varying within the range 0,01 - 100,00 cm/s, preferably within the range 0,2 - 3,0 cm/s.

According to a further aspect of the invention, after step A, the following step may be executed:
D. depositing a layer of refractory metal on one or more side walls of the absorber.

According to an additional aspect of the invention, step B may comprise the following sub-step:
B.1 depositing diamond thin film of thickness lower than 25 micrometers on said inner surface of the absorber through CVD, preferably through microwave CVD or through hot-filament CVD, having methane and hydrogen as precursor gases, the methane-to-hydrogen precursor gas ratio ranging from 0,05% to 5%, being preferably equal to 1%,
   whereby the thermionic emitter is made of a material selected from the group comprising or consisting of:
   - thin film diamond of thickness lower than 25 micrometers deposited through CVD,
   - thin film diamond of thickness lower than 25 micrometers deposited through CVD having a n-type doping,
   - thin film diamond of thickness lower than 25 micrometers deposited through CVD having surface chemical termination with monoatomic hydrogen and/or depositions of zirconium and/or caesium,
   - thin film diamond of thickness lower than 25 micrometers deposited through CVD having a n-type doping and having surface chemical termination with monoatomic hydrogen and/or depositions of zirconium and/or caesium,
   wherein preferably sub-step B.1 is performed in a CVD reactor having an atmosphere in which a nitrogen gas is introduced, whereby the thermionic emitter is preferably made of a material selected from the group comprising or consisting of:
   - thin film diamond of thickness lower than 25 micrometers deposited through CVD having a n-type doping,
   - thin film diamond of thickness lower than 25 micrometers deposited through CVD having a n-type doping and having surface chemical termination with monoatomic hydrogen and/or depositions of zirconium and/or caesium,
   step B preferably further comprising, after sub-step B.1, the following sub-step:
B.2 exposing the diamond thin film obtained from step B.1. to hydrogen plasma so as to cause a hydrogen monoatomic layer to stick on a diamond surface,
   whereby the thermionic emitter is preferably made of a material selected from the group comprising or consisting of:
   - thin film diamond of thickness lower than 25 micrometers deposited through CVD having surface chemical termination with monoatomic hydrogen and/or depositions of zirconium and/or caesium,
   - thin film diamond of thickness lower than 25 micrometers deposited through CVD having a n-type doping and having surface chemical termination with monoatomic hydrogen and/or depositions of zirconium and/or caesium.

According to another aspect of the invention, step B may comprise the following sub-step:
B.3 depositing lanthanum hexaboride (LaB₆) through physical vapour deposition (PVD), preferably followed by a treatment of a surface of the thermionic emitter through femto-second laser, and/or through pulsed laser deposition (PLD), and/or through radio frequency cathodic sputtering (RF sputtering) technique on said inner surface of the absorber,
whereby the thermionic emitter is made of lanthanum hexaboride (LaB₆), preferably nanostructurated, thin film of thickness lower than 25 micrometers, preferably not larger than 1 micrometer, more preferably not larger than 800 nanometers, still more preferably not larger than 700 nanometers, even more preferably not larger than 600 nanometers, even still more preferably not larger than 500 nanometers, still even more preferably not larger than 400 nanometers.

According to a further aspect of the invention, the process may further comprise, after step C, the following step:
E. making on the thermionic collector a first layer, configured to operate as hot side of a thermoelectric module, of a ceramic material selected between diamond deposited through CVD or aluminium nitride deposited through screen printing or geopolimeric coating,
whereby the converter device is the converter device described above that comprises a thermoelectric module.

According to an additional aspect of the invention, the process may further comprise, after step E, the following step:
F. depositing selectively through PVD a plurality of thermoelectric elements of electroconductive carbide and/or boride-based ceramic material on the first layer obtained from step E,
or the following step:
G. depositing on the first layer obtained from step E through PLD and/or through RF sputtering a lead telluride thin film at temperatures higher than 300 °C and lower than 700 °C, preferably ranging from 400°C to 550 °C, the lead telluride thin film being selectively n-type doped through a subsequent deposition of antimony telluride and being selectively p-type doped through subsequent deposition of silver, the lead telluride thin film being spatially defined according to an arrangement of thermoelectric elements, the deposition through PLD and/or through RF sputtering preferably comprising the following sub-steps:
G.1. depositing lead telluride starting from ablation of a monocrystalline or polycrystalline lead telluride target with purity of 99,995%,
G.2 performing an ablation of a antimony telluride target with purity of 99,995% for selectively introducing atoms of antimony into the lead telluride thin film obtained from sub-step G.1 and obtaining a n-type doping,
G.3 performing an ablation of a silver target with purity of 99,995% for selectively introducing atoms of silver and obtaining a p-type doping,
G.4 spatially defining the doped lead telluride thin film obtained from sub-steps G.1-G.3 through photolithographic techniques combined with chemical dissolution techniques for obtaining the arrangement of thermoelectric elements,
the process preferably further comprising, after step F or G, the following step:
H. making a second layer, configured to operate as cold side of the thermoelectric module, of a ceramic material selected between diamond deposited through CVD or aluminium nitride deposited through screen printing or geopolimeric coating.

The active components of the converter device according to the invention are the electromagnetic radiation absorber, a thermionic module comprising an emitter and a collector, and possibly a thermoelectric module; in this regard, any form of electromagnetic radiation is intended with electromagnetic radiation including, in particular, the solar radiation and the microwave radiations. Thanks to such components, the converter device is capable to produce electric energy and, in the preferred embodiment comprising the two converter modules (which implement a two-stage conversion), also thermal energy. The electromagnetic radiation absorber is an efficient photo-thermal converter made of a material selected between ceramic materials, refractory metals and pyrolitic graphite.

The converter device according to the invention operates in vacuum conditions, rendering both conversion stages, i.e. thermionic one and thermoelectric one, capable to efficiently convert the thermal energy directly to electric energy, without moving parts, in a compact, reliable and easy to control manner.

The present invention will be now described, by way of illustration and not by way of limitation, according to its preferred embodiments, by particularly referring to the Figures of the annexed drawings, in which:
Figure 1 shows a schematic representation (Fig. 1a) and the related temperature profile (Fig. 1b) of a first preferred embodiment of the converter device according to the invention;
Figure 2 shows a front perspective view (Fig. 2a) and a rear perspective view (Fig. 2b) of a second preferred embodiment of the converter device according to the invention;
Figure 3 shows an exploded front perspective view of the converter device di Figure 2;
Figure 4 shows a exploded rear perspective view of the converter device di Figure 2; and
Figure 5 shows a perspective view (Fig. 5a) and a plan view (Fig. 5b) of a component of a third preferred embodiment of the converter device according to the invention.

In the Figures identical reference numerals will be used for alike elements.

In the following of the present description some values of pressure are given, rather than in the unit of measurement of the International System (i.e. Pascal), in the units of measurement bar (1 bar = 10⁵ Pascal), millibar (1 mbar= 100 Pascal) and torr (1 torr = 133,3223684 Pascal).

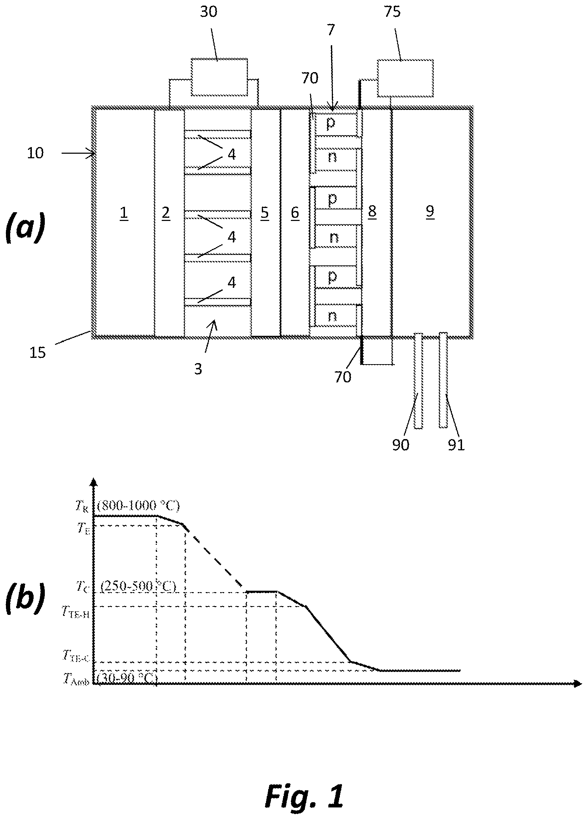

With reference to Figure 1a, it may be observed that the preferred embodiment of the converter device according to the invention comprises an absorber 1 of solar radiation (or other electromagnetic radiation), that transforms the solar radiation energy to thermal energy, having an outer surface 10 exposed to the solar radiation and an inner surface integrally coupled to a thermionic emitter (or cathode) 2, separated by an inter-electrode space 3 from a thermionic collector (or anode) 5 through thermally and electrically insulating spacers 4. The distance between thermionic emitter 2 and collector 5 in the inter-electrode space 3 is shorter than 1 mm and preferably shorter than 10 µm; the spacers 4 are not an essential feature to the invention, rather they are optional. The thermionic collector 5 is integrally coupled to a first thermally conductive and electrically insulating layer 6, in turn integrally coupled to a plurality of thermoelectric elements 7 provided with interconnecting tracks 70; in particular, the thermoelectric elements 7 are preferably semiconductor elements (shown schematically in Figure 1a through pairs of p-type and n-type doped elements), or, alternatively or in combination with the semiconductor elements, pairs of elements made of metals with different work function. The plurality of thermoelectric elements 7 is in turn integrally coupled to a second thermally conductive and electrically insulating layer 8, in turn integrally coupled to a heat sink 9, that can be either passive or active and that, in active configuration (shown in Figure 1a), is provided with an inlet 90 and an outlet 91 for the cooling liquid. In particular, the first layer 6 and the second layer 8 operate, respectively, as hot side and cold side of the thermoelectric converter module. With reference to Figure 1b, the absorber 1 operates at a temperature T_{R}, ranging from 600°C to 1100°C, preferably ranging from 800°C to 1000°C, and the thermionic emitter 2 operates at a temperature T_{E} close to T_{R} (T_{E} ≅ T_{R}); the thermionic collector 5 and the first layer 6 operate at a temperature T_{C} much lower than T_{E} (T_{C} << T_{E}), preferably ranging from 25% to 65% of T_{E}, more preferably ranging from 250°C to 500°C. In Figure 1, the electrical loads supplied by thermionic module and by the thermoelectric module, respectively, are shown schematically by blocks 30 and 75.

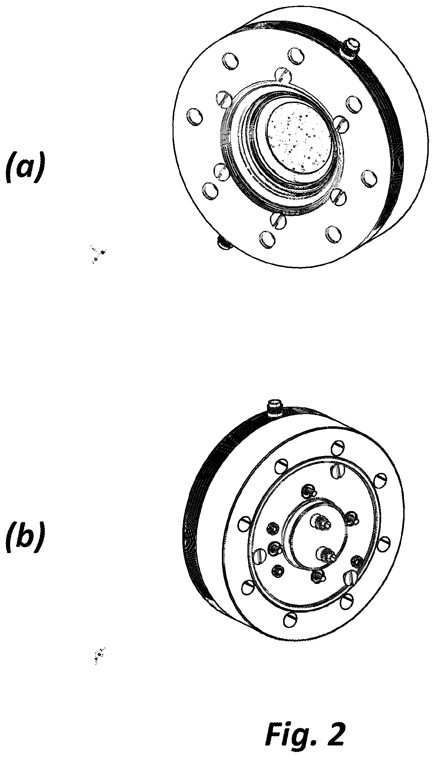

The absorber 1, the thermionic emitter 2, the possible spacers 4, the thermionic collector 5, the first layer 6, the thermoelectric elements 7 and the second layer 8 are housed in a case 15 ensuring vacuum conditions, preferably such that the pressure inside the case 15 is lower than 10⁻⁵ mbar; the housing case 15 comprises a transparent window (not shown in Figure 1) that optically transmits the concentrated solar radiation towards the outer surface 10 of the absorber 1. In Figure 1a, also the sink 9 is represented as housed within the case 15; however, the sink 9 may be also placed outside the case 15 and in contact with the latter (as shown for the embodiment of Figure 2 of the converter device according to the invention).

The absorber 1 is made through high temperature sintering techniques, while the thermionic emitter 2 is made through processes of microfabrication which are typical for semiconductor devices. Moreover, also the possible spacers 4 and the thermionic collector 5, as well as the possible thermoelectric module (comprising the first layer 6, the thermoelectric elements 7 and the second layer 8) are preferably made through processes of microfabrication typical for semiconductor devices.

Values of T_{R} ranging from 600°C to 1100°C, preferably from 800°C to 1000°C, are sufficient to adequately supply thermal energy for the electron emission from the emitter 2; to this end, the emitter 2 has a high thermal conductivity for reaching a temperature T_{E} as close as possible to that of the absorber 1 (T_{R} ≅ T_{E}) and hence for minimising possible thermal losses. The collector 5 is not directly coupled to the emitter 2, whereby the temperature profile would, ideally, show a discontinuity down to the value T_{C} that would be purely determined by the absorption of the black body radiation emitted by the assembly absorber 1-emitter 2; actually, the emitter 2 and the collector 5 are separated by spacers 4 coupled to them which, although made of material with low thermal conductivity, increase T_{C} with respect to the ideal case and which render the temperature profile linear as shown in Figure 1b. Preferably, T_{C} ranges from 250°C to 500°C, whereby the temperature difference with respect to T_{E} is capable to optimise the operation of the two thermionic and thermoelectric stages.

The first layer 6 is thermally conductive, so that its temperature is as close as possible to T_{C}, and electrically insulating, for avoiding dispersions of the output current of the thermionic module (i.e. current dispersions from the thermionic collector 5) and from the interconnecting tracks 70 of the thermoelectric pairs 7 in contact with the first layer 6. The plurality of thermoelectric elements 7 preferably comprises thermoelectric pairs of semiconductor elements with p-type and n-type doping, operating as active materials of the thermoelectric module, electrically connected in series to each other, which work between a temperature T_{TE-H} of the first layer 6 (hot side) and a temperature T_{TE-C} of the second layer 8 (cold side). In particular, T_{TE-H} is as close as possible to T_{C}, while T_{TE-C} is determined by controlling the maximum temperature T_{Amb} of the heat rejection apparatus formed by the heat sink 9 , preferably liquid-cooled. By using a sufficiently efficient heat sink 9, T_{Amb} is close to T_{TE-C}; preferably, T_{Amb} ranges from 0°C to 90°C, more preferably T_{Amb} ranges from 30°C to 90°C depending on the specific application of the converter device according to the invention, wherein the electric output of the same device can be maximised (whereby T_{Amb} is as close as possible to room temperature or it can be even brought, through energy consumption, at a temperature slightly higher than the freezing one of the cooling liquid) or the cogeneration capability is combined thereto (whereby T_{Amb} is high for allowing the residual thermal energy to be exploited) or finding an intermediate solution that optimises each output (i.e. both the thermionic and thermoelectric output, and the thermal output, whereby T_{Amb} has an intermediate value).

The material of the absorber 1 has, first of all, an absorbance in the solar radiation spectrum (in terms of percentage of power of absorbed radiation with respect to the impinging one) as high as possible for increasing the efficiency of conversion from concentrated radiation to thermal energy; in fact, the higher the absorbance of the material of the absorber 1, the higher the capability of the absorber 1 of entrapping the concentrated light on it and consequently the higher the operating temperature obtained at the same radiation flow. Moreover, the material of the absorber 1 preferably has an emission of black body radiation as low as possible for minimising the energy losses and avoiding the heating of the surrounding elements. Also, such material has a melting point that is higher, advantageously much higher, than the operating temperatures (ranging from 600°C to 100°C, preferably from 800°C to 1000°C) of the converter device according to the invention. Furthermore, the material of the absorber 1 preferably has mechanical resistance at high temperatures. Moreover, such material advantageously has a thermal stress (or shock) resistance as high as possible so as to be able to deal with critical variations of the operating temperatures (e.g. caused by sudden variations in weather conditions or errors in sun tracking by the concentration optics). Also, the material of the absorber 1 preferably has an electrical resistivity as low as possible for providing the thermionic emitter 2 with a sufficient refilling of electrons. Finally, such material advantageously has a thermal expansion coefficient and a lattice structure compatible with those of the material of the thermionic emitter 2.

The material of the absorber 1 of the converter device according to the invention is selected among ceramic materials (which have a high thermal and mechanical stability at the operating temperatures of the converter device according to the invention), as defined in claims 1 and 2.

In the hafnium carbide-based materials and in the silicon carbide-based materials, the molybdenum silicide has the role of stabilising the structure and reducing mechanical stresses and internal strains. However, the molybdenum silicide also causes a decrease of the solar radiation absorption capability. The realisation of a sub-micrometer periodic surface structure (known as texturing) on the outer surface 10 of the absorber 1 compensates such decrease of absorbance with a higher light trapping capability.

As stated, the outer surface 10 of the absorber 1 is provided with a sub-micrometer periodic surface structure, preferably made through femto-second laser, for increasing the absorbance of the absorber 1 in a wide range of wavelengths, mainly in the regions of visible (with wavelengths ranging from 380 to 750 nanometers) and near infrared (with wavelengths ranging from 750 nanometers to 1,4 micrometers). The treatment through femto-second laser may be carried out by making the laser beam directly impinge the surface of the material to treat (i.e. the outer surface 10 of the absorber 1) in high-vacuum conditions, in air or in reactive atmosphere with the following parameters (which, however, must be considered not as essential to the invention but as purely illustrative):
- laser wavelength ranging from 200 to 1000 nanometers, preferably from 550 to 800 nanometers, still more preferably equal to 800 nm;
- duration of single laser pulse ranging from 10 to 100 femto-seconds;
- impingement of the laser beam with an angle with respect to the normal to the surface to treat (i.e. the outer surface 10 of the absorber 1) ranging from 0° to 60°, preferably with impingement orthogonal to the surface to treat, i.e. with an angle with respect to the normal to the surface to treat equal to 0°;
- laser pulse energy varying within the range 0,01 - 5,00 mJ/pulse, preferably within the range 0,2 - 2,0 mJ/pulse;
- spot focusing having diameter ranging from 5 µm ad 1 mm, preferably ranging from 100 µm a 0,5 mm;
- speed of the translational plate on which the material to treat under the laser beam varying within the range 0,01 - 100,00 cm/s, preferably within the range 0,2 - 3,0 cm/s. During the treatment, the laser wavelength is preferably kept constant.

Such treatment induces a significant increase in the absorption efficiency of the absorber 1, reducing the differences of absorbance of the different materials of which the absorber 1 may be made; in particular, the value of the solar radiation absorbance of the absorber 1 having the surface 10 treated as above reaches values larger than 90%. In fact, the surface 10, provided with the sub-micrometer periodic surface structure (that, with the aforementioned example parameters of the femto-second laser, is composed of lines spaced apart by about 800 nm, i.e. the laser wavelength), acts as diffraction grating enabling a trapping of the radiation impinging in the surface 10 of the absorber 1.

For improving the characteristics of thermal emission of the absorber 1, the thermal losses of the latter may be drastically reduced if not entirely eliminated by depositing a thin layer of refractory metal on the side walls of the absorber (i.e. on the surfaces different from the outer surface 10 and from the inner surface) and/or by depositing a very thin layer of infrared reflecting material on the inner surface of the housing case 15 of the converter device.

The absorber 1 preferably has a shape of a disc. By way of example and not by way of limitation, the absorber 1, having shape of a disc, may have a diameter ranging from 30 mm to 50 mm and a thickness ranging from 3 mm to 10 mm. In this regard, the radiation flow distribution for any material of which the absorber 1 is made is almost entirely absorbed in the first layers of the latter (in correspondence of the outer surface 10). This implies that the thickness of the absorber 1 does not affect the absorption efficiency and the most proper thickness is the smallest technically feasible (e.g. 3 mm), that is sufficient to attenuate possible hot-spots of the concentrated radiation and to maximise the thermal conduction in the whole body of the material towards the thermionic emitter 2.

The disc shape of the absorber 1 has the advantages of the scalability, fabrication simplicity and capability of being easily surface-treated on the outer surface 10 and of allowing the deposition of the material of the thermionic emitter 2 on the inner surface.

In fact, the thermionic emitter 2 is made directly on the inner surface of the absorber 1, in particular through a deposition allowing a monolithic integration of the thermionic stage on the absorber 1. In other words, the material of the thermionic emitter 2 forms stable physical bonds with the material of the absorber 1.

The material of the thermionic emitter 2 is selected among:
- thin film diamond deposited through chemical vapour deposition, also known as CVD, of thickness lower than 25 µm, preferably lower than 10 µm, more preferably lower than 5 µm, still more preferably lower than 1 µm;
- ceramic materials for high temperature applications comprising titanium nitride (TiN), molybdenum silicide, carbides(such as hafnium carbide, titanium carbide - TiC -, zirconium carbide - ZrC -, and tungsten carbide - WC)-based materials, and borides(such as titanium boride - TiB₂ -, and zirconium boride - ZrB₂)-based materials; possibly, such ceramic materials may comprise additives, such as aluminium oxide and/or yttrium oxide, and/or metal phases consisting of fine metal or intermetallic particles;
- other materials known for their capability of electron emission at temperatures (higher than 1300°C) higher than the operating one of the converter device according to the invention, such as lanthanum boride (LaB₆), and refractory metals such as molybdenum and tungsten; for the use in the converter device according to the invention, the emission temperature of such materials is lowered by depositing such materials in thin film form (with thickness not larger than 1 micrometer, preferably not larger than 800 nanometers, more preferably not larger than 700 nanometers, still more preferably not larger than 600 nanometers, even more preferably not larger than 500 nanometers, even still more preferably not larger than 400 nanometers) through physical vapour deposition, also known as PVD, and/or by inducing nano-structuring during the process of growth of the film and/or by means of post-treatment through femto-second laser and/or reactive plasma.

In particular, the CVD diamond is the preferred material for the thermionic emitter 2 since it ensures a very high thermal conductivity (1000-2000 W·m⁻¹·K⁻¹), it has a low work function energy caused by the negative electron affinity, capable to induce an excellent capability of thermally emitting electrons even at not too high temperature, i.e. at 600°C. Moreover, the CVD diamond has the technological advantage that it can be deposited on large surfaces (e.g. on 10 inches wafer - where 1 inch = 2,54 cm) and physical properties which can be adapted as a function of the specific application by varying the deposition parameters. In this regard, its work function can be tailored by acting on:
- a proper thermally stable surface chemical termination, e.g. by means of processes of surface termination with monoatomic hydrogen and/or depositions of zirconium and/or caesium;
- a n-type doping with nitrogen during the deposition process.

As stated, the material of the thermionic emitter 2 is directly deposited on the inner surface of the absorber 1; the preferred embodiment of the converter device according to the invention uses for such material the CVD diamond that is deposited through one of two possible techniques: microwave CVD and hot-filament CVD. In particular, in the microwave CVD technique it is possible to deposit diamond films with n-type doping having dopant concentration higher than what obtainable through the hot-filament CVD technique. The n-type doping, that is obtained by introducing an extremely pure nitrogen gas in the atmosphere of the CVD reactor, allows to improve the thermionic emission of the diamond, since it induces a shift of the Fermi level closer to the conduction band of the material, whereby the energy barrier to release moving electrons is reduced. The microwave and hot-filament CVD techniques use the same thermodynamic parameters, namely methane and hydrogen as precursor gases, a substrate temperature from 600°C to 900 °C, preferably from 700°C to 800°C, and a gas pressure from 5 to 100 Torr, preferably from 15 to 40 Torr; the two techniques differ only in the method of activation of the precursor gases. In particular, the methane-to-hydrogen precursor gas ratio determines the structural quality of the diamond grains in the film that is grown; such ratio may range from 0,05% to 5%, and it is preferably equal to 1%.

The mechanical stability of the diamond films on a specific substrate depends on the compatibility of its lattice structure and its thermal expansion coefficient with those of the substrate, i.e. of the material of the absorber 1. In particular, the compatibility of the lattice structures is responsible for the stability of the diamond chemical bonds on the substrate (i.e. for its adhesion), while the compatibility of the thermal expansion coefficients is related to the thermal stability at high temperatures and during thermal cycles. In particular, the CVD diamond generally has a good compatibility of the lattice structure with carbides and nitrides, and a lower compatibility with silicide.

The CVD diamond film of the thermionic emitter 2 deposited on the absorber 1 preferably has a thickness ranging from 0,1 to 15 µm, more preferably ranging from 0,1 to 3 µm. In particular, the higher the molybdenum silicide concentration in the material of the absorber 1, the more the CVD diamond grown thereon suffers from mechanical stresses, which however are diminished if the material of the absorber 1 is based on elements having a full lattice compatibility with diamond, such as silicon carbide and aluminium nitride.

As previously mentioned, the diamond surface undergoes a treatment stabilising its surface chemical termination, e.g. by obtaining a termination with hydrogen, that induces a lowering of the electron affinity down to negative values, whereby the free moving electrons which are situated close to the surface experience a very low (or even null) energy barrier for escaping towards the vacuum, thus improving the electron emission. The termination with hydrogen is obtained by exposing the CVD diamond films to hydrogen plasma in process conditions such to allow a hydrogen monoatomic layer to "stick" on the diamond surface.

A first advantageous alternative to the CVD diamond as material of the thermionic emitter 2 is nanostructurated lanthanum hexaboride (LaB₆), made in thin films through pulsed laser deposition, also known as PLD (Pulsed Laser Deposition), and/or through radio frequency cathodic sputtering (RF sputtering) technique, with thicknesses preferably ranging from 200 nanometers to 800 nm, more preferably equal to 500 nanometers, which allows to render film adhesion to the absorber 1 less critical. The PLD and/or RF sputtering deposition is preferably performed starting from a target of lanthanum hexaboride with purity of 99,9995% on ceramic samples and of molybdenum and/or tungsten.

A second advantageous alternative to the CVD diamond as material of the thermionic emitter 2 is a hafnium carbide-based material, still made in thin films with similar thicknesses (lower than 500 nanometers). When also the absorber 1 is of hafnium carbide, this allows to have a single material with the advantage of eliminating all the previously cited problems, e.g. in relation to the thermal stability and lattice structure compatibility.

The material of the thermionic collector 5 is selected as a function of the material of the thermionic emitter 2, in order to make their work functions properly match. In this regard, the most versatile materials are molybdenum or tungsten preferably coated with caesium, the work function of which can be tailored by varying the percentage of caesium present on the surface of molybdenum or tungsten.

The thermoelectric module of the converter device according to the invention comprises the first layer 6 (hot side), the plurality of thermoelectric elements 7, and the second layer 8 (cold side). The primo and second layers 6 and 8 are thermally conductive and electrically insulating for avoiding electrical dispersions and thermal losses at the ends of the thermoelectric module. These layers are advantageously made of ceramic materials, such as for instance intrinsic CVD diamond or aluminium nitride deposited through screen printing or geopolimeric coating (that does not need high temperatures for consolidating the coating). The plurality of thermoelectric elements 7 can be made of:
- a bismuth telluride (Bi₂Te₃) and antimony telluride (Sb₂Te)-based material for a low-scale power generation from room temperature up to about 250°C;
- a lead telluride (PbTe)-based material for applications at operating temperatures within the range 230°C- 530°C;
- a silicon germanium (SiGe) alloy-based material for applications at operating temperatures higher than 530°C.

The material of the thermoelectric elements 7 may be also selected from the group of materials comprising doped barium and strontium titanate and lanthanate-based materials, PVD deposited electroconductive carbides and borides-based materials, silicon carbide and silicon-silicon carbide-based materials, boron carbide-titanium boride (B₄C-TiB₂)-based materials, and un metal-ceramic composite materials.

In the preferred embodiment of the converter device according to the invention, the material of the thermoelectric elements 7 is lead telluride deposited in thin film at temperatures higher than 300 °C and lower than 700 °C, preferably ranging from 400°C to 550°C through PLD technique and/or through RF sputtering and n-type doped through a subsequent deposition of antimony telluride and p-type doped through deposition of silver. The PLD and/or RF sputtering deposition technique is capable to induce a nanostructuring of the deposited film that hampers the material thermal conductivity maintaining its electrical conductivity constant, whereby the Seebeck coefficient of the material is enhanced. By way of example, the PLD and/or RF sputtering deposition may base on a prolonged step of deposition of lead telluride starting from the ablation of a mono- or poly-crystalline telluride target with purity of 99,995%, and a subsequent brief ablation a) of an antimony telluride target with purity of 99,995% for introducing atoms of antimony into the lead telluride film and obtaining a n-type doping (the antimony atoms have the proper diffusivity for doping the lead telluride film); b) of a silver target with purity of 99,995% and obtaining a p-type doping. For obtaining the sequence of p-type and n-type thermoelectric elements and spatially defining the device structure (i.e. "patterning"), Photolithographic techniques combined with chemical dissolution techniques are used, as known in microelectronics fabrication processes.

In this regard, the innovative thermoelectric module made with the thermoelectric elements 7 of lead telluride deposited in thin film through PLD and/or RF sputtering techniques, as just described, is also usable independently from the thermionic module, i.e. for making a purely thermoelectric converter device.

The cooling liquid in the heat sink 9 is preferably a solution of deionized water and ethylene glycol, preferably in proportion 50%-50%, in order to prevent formation of solid residuals, electrical dispersions, and temperature driven chemical reactions. Alternatively, the cooling liquid may comprise demineralized water.

Other embodiments of the converter device according to the invention may comprise, instead of the heat sink 9, a simple heat exchanger that is properly sized.

Figures 2-4 show an implementation of a second preferred embodiment of the converter device according to the invention, comprising as housing case a flange DN63CF (according to ConFlat® standard, also known as CF standard) of stainless steel modified as described below, indicated with reference numeral 100, thanks to which the device is compact and versatile, thus minimising the optical losses with a minimum distance ranging from 1,0 to 10,0 mm, preferably equal to 5,0 mm, between window 101 and the monolithic assembly 102 of the absorber and thermionic emitter and thus greatly reducing the device size.

The transparent window 101 may be a UV quartz lens (UV-grade fused silica) and/or glass and/or pyrex of thickness ranging from 1,00 mm to 10,00 mm, preferably equal to 5,00 mm, and of diameter ranging from 35,0 mm to 100,00 mm, preferably equal to 50,0 mm. An o-ring 103 of viton (possibly replaced or combined with at least one copper and/or aluminium seal) is placed under the window 101 for ensuring vacuum tightness inside the flange 100.

A heat sink 900 comprises two separated copper components welded together for forming a cavity wherein a cooling liquid flows for extracting heat from the window 101 and from the front part of the device. Alternatively, the heat sink 900 could comprise a single copper or aluminium component provided with two o-rings (external to the o-ring 103 of the transparent window 101) for delimiting a cavity wherein the cooling liquid flows. The inlet and outlet connections 909 for the liquid are preferably made with standard VCR® connectors (available from the company Swagelok). The presence of the sink 900 is necessary for controlling the temperature increase of the window 101 and in the case of non-optimal focusing of the concentrated radiation. The sink 900 is shaped so as to maximise the solar radiation impingement on the absorber: the through hole allowing lighting is shaped as a cone frustum with the inner walls having an inclination with respect to the vertical axis of the cone equal to the inclination angle of the concentrated radiation beam, that preferably is equal to 45°.

The flange 100 has a thickness of 24,0 mm and is shaped for housing the absorber and the thermionic and thermoelectric modules. In the rear part, the flange 100 comprises three (or, alternatively, four) angularly equally spaced threaded holes 104 in which corresponding screws 105 insert for mechanically fixing the active part of the device (i.e. absorber and thermionic and thermoelectric module) to the flange 100. In the front part, the flange 100 comprises six angularly equally spaced threaded holes 106 corresponding to the same number of through holes 906 made on the sink 900, in which corresponding screws 107 insert for mechanically fixing the sink 900 to the flange 100. The other eight through holes 960, corresponding to the same number of through holes 1060 obtained on the flange 100, have the function of anchoring the whole system on a possible support by means of through screws not shown in Figures 2-4.

The flange 100 is provided with a housing for a copper or aluminium gasket 111L supporting the conversion module coupled to an aluminium (or alternatively copper) disc 111U provided with two VCR® standard connectors 119 for the external hydraulic circuit of the cooling liquid.

A properly shaped molybdenum ferrule 108 constitutes the housing of the assembly absorber-thermionic emitter 102. The molybdenum ensures a good thermal and electrical contact with the absorber and a thermionic electrical output is connected to the electrical load (that, although not shown in Figures 2-4, is similar to that indicated in Figure 1a with reference numeral 30) by means of four molybdenum screws 109 which are angularly equally spaced and electrically in parallel. This configuration offers a high versatility for different operating conditions of the device, since it is possible to choose the number of screws 109 to electrically connect to the load so as to optimise the thermal losses from the absorber (in combination with the thermally insulating ceramic caps 110 described below). Moreover, this configuration renders the device compact and robust since the integration of the active part of the device to the supporting copper gasket 111L-111U is very solid. Geometrically, the shape of the ferrule 108 has four hollow wings which have the function of maintaining optimal vacuum conditions for the thermionic module.

As previously stated, the absorber has a disc shape with a thickness of 3,0 mm and a diameter of 35,0 mm on the inner surface of which a thin layer of CVD diamond of few micrometers of thickness is deposited, thus forming a monolithic assembly 102.

A spacer 112, made of thermally refractory and electrically insulating material (such as zirconia or alumina or glass ceramic MACOR®) keeps the thermionic emitter of the assembly 102 and the thermionic collector 5 separated by the minimum possible distance, preferably lower than 100 micrometers. Also the spacer 112 has three (or four) hollow wings for maintaining optimal vacuum conditions inside the inter-electrode space 3.

The thermionic collector 5 is a molybdenum disc of thickness 4,0 mm, capable to obtain a proper heat dissipation at high temperatures for offering to the thermoelectric module a wider range of protection. The surfaces of the collector 5 are preferably lapped with diamond powder for obtaining a higher reflectance to black body radiation coming from the assembly absorber-thermionic emitter 102 and consequently for reducing its work temperature, besides maximising the thermal conduction towards the thermoelectric module hot side. The disc of the thermionic collector 5 comprises a radially projecting pin 500 that is provided with a through hole for electrically connecting the collector 5 to its electrical load. The electrical connection is made through a copper stud 113 crossing the gasket 111L-111U through a hollow spindle 114 of boron nitride or glass ceramic MACOR® (if a high thermal insulation is necessary).

The thermoelectric module 115 has parallelepiped shape (although alternatively it may also have a cylindrical shape), having square base of side size 40x40 mm² and a thickness ranging from 3,0 mm to 6,5 mm. The thickness variation may be compensated by using metal spacers with screws of different length (not shown) within the range 3,0-5,5 mm for keeping the distance between the window 101 and the absorber of the assembly 102 constant.

As stated, the supporting copper gasket comprises a lower part 111L and an upper part 111U which are welded together for forming an internal cavity wherein a cooling liquid flows, thus implementing the heat sink 9 schematically shown in Figure 1, for thermostatically controlling the cold side of the thermoelectric module 115 at the maximum heat rejection temperature. Alternatively, the parts 111L and 111U may be coupled through two o-rings of viton defining the internal cavity wherein the cooling liquid flows.

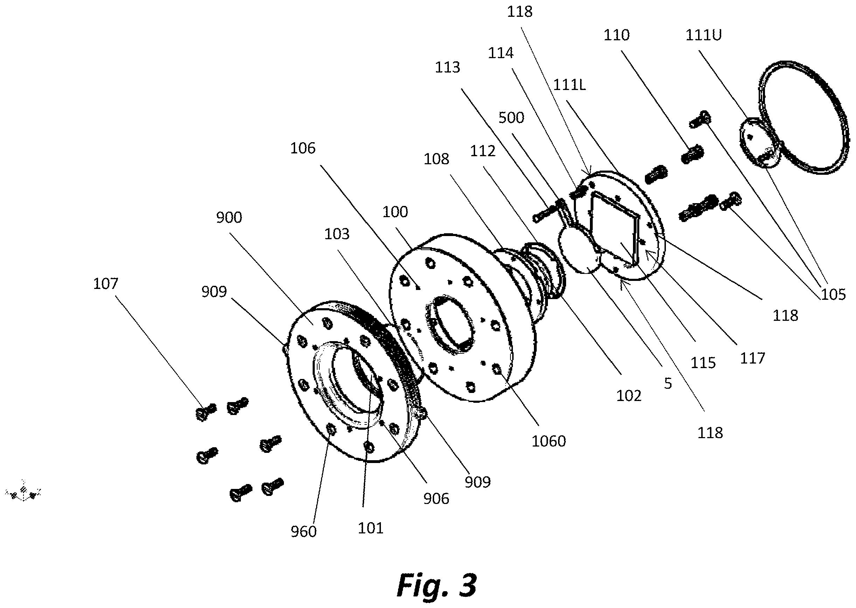

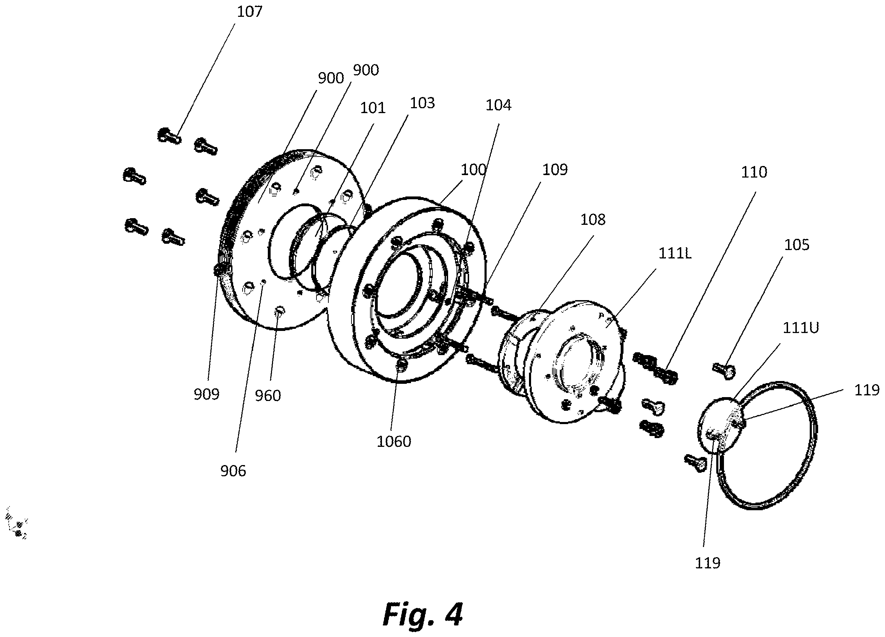

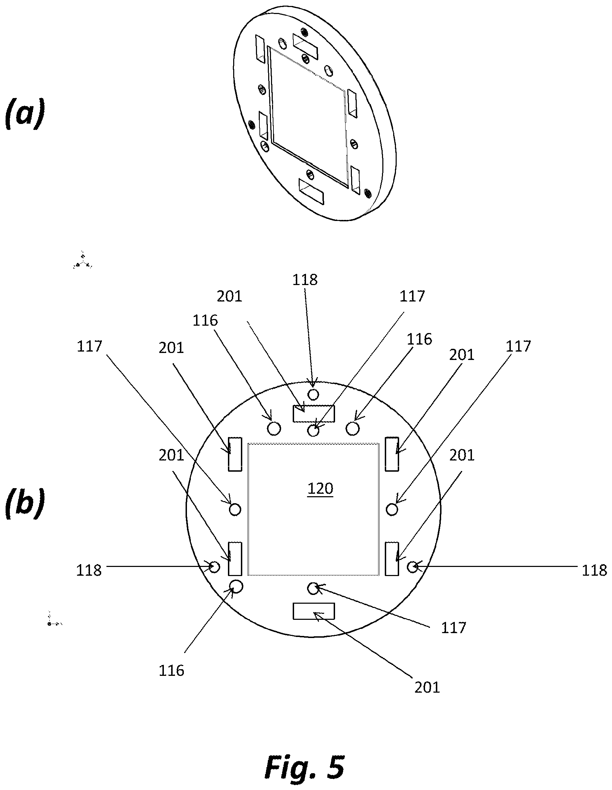

In particular, the lower part 111L of the supporting copper gasket is provided with a square central notch (of 1 mm of depth) for housing the thermoelectric module 115 and for favouring the heat conduction from the cold side of the latter. The lower part 111L of the gasket is provided with three through holes 116 (viewable in Figure 5, referring to a supporting copper gasket of a third embodiment of the device according to the invention that, however, also comprises such holes 116) for the electrical connections, two of which are intended for the thermoelectric module 115 and connecting the same to the electrical load (that, although not shown in Figures 2-4, is similar to that indicated in Figure 1a with reference numeral 75) and one for the stud 113 of the thermionic collector 5. Also, the lower part 111L of the gasket is further provided with four holes 117 which are electrically shielded for the outputs of the thermionic module coming from the ferrule 108 (with the function of electrical connection and fixing of the internal part of the thermionic module), and three (or, alternatively, four) equally spaced holes 118 for securing screws (with the function of locking the internal part of the device to the flange 100); in particular, the short distance between the gasket 111L-111U and the threaded holes 104 on the flange allows to obtain a high mechanical stability. All the electrical connections crossing the gasket 111L-111U are electrically insulated by ceramic spindles 110 (of which in Figures 3 and 4 only those passing in the holes 117 are viewable) of boron nitride, that is a material allowing thermal conduction.

In the device of Figures 2-4, the o-ring 103, the flange 100, the ferrule 112 and the supporting copper gasket 111L-111U are sealed together through brazing or other conventional sealing techniques in high-vacuum or ultra- high-vacuum conditions.

A supporting copper gasket of a third embodiment of the device according to the invention is shown in Figure 5, wherein the device is provided with an additional pumping apparatus and the gasket is provided with six, preferably rectangular, through holes 201 allowing evacuation of the air extracted by such pumping apparatus. In Figure 5 also the other through holes 116, 117, 118 and the notch 120 (for housing the thermoelectric module 115) present also in the gasket 111L-111U of Figures 2-4 are better viewable.

The converter device shown in Figures 2-5 is compact, having a reduced volume for minimising the thermal and optical losses and for reducing the effects of optical shadowing of the non-concentrated solar radiation. Moreover, it allows an easy interchangeability of the components (in particular of the thermoelectric module 115), since each component may be easily mounted and dismounted thus favouring a strategy of continuous optimisation of performance of the converter device according to the invention. Still, the device is completely scalable in size with respect to the one illustrated with reference to Figures 2-5. Finally, the converter device is mechanically robust, thanks to the technique of fixing of the active elements (i.e. the assembly absorber-thermionic emitter 102, the thermionic collector 5, and the thermoelectric module 115) to the flange 100.

As mentioned, the converter device according to the invention could be advantageously used also in aerospace applications. In this case, the converter device according to the invention may operate with very high efficiency in low or almost null pressure conditions which are typical for the aerospace applications, i.e. in operative environments outside the earth's atmosphere, wherein the vacuum condition for the operation of the thermionic module and thermoelectric module is intrinsic to the same application; in particular, in an aerospace application it could be even possible to eliminate the presence of a housing case provided with window within which the vacuum conditions should be implemented (since it is substantially sufficient the mounting on a support similar to the gasket 111L-111U shown in Figures 2-4), thus simplifying the mounting of the converter device according to the invention. Consequently, the housing case provided with window within which the vacuum conditions should be implemented is not an essential feature to the converter device according to the invention.

The preferred embodiments of this invention have been described and a number of variations have been suggested hereinbefore, but it should be understood that those skilled in the art can make other variations and changes, without so departing from the scope of protection thereof, as defined by the attached claims.

## Claims

1. Converter device for converting energy from electromagnetic radiation, in particular concentrated solar energy, in electrical power, comprising a thermionic emitter (2) separated by an inter-electrode space (3) from a thermionic collector (5), the thermionic emitter (2) and the thermionic collector (5) being provided with electrical connection means (109, 110, 113, 114, 500) configured to be connectable to a first external electrical load (30) for supplying electrical power, the converter device being **characterised in that** it further comprises an absorber (1) of electromagnetic radiation, configured to transform electromagnetic radiation energy to thermal energy, having an outer surface (10) configured to be exposed to electromagnetic radiation and an inner surface integrally coupled to the thermionic emitter (2), the outer surface (10) being provided with a sub-micrometer periodic surface structure, the thermionic emitter (2) being monolithically integrated on said inner surface of the absorber (1), the absorber (1) being made of a material selected from the group comprising or consisting of:
- ceramic materials selected from the group comprising or consisting of:
hafnium carbide (HfC)-based ceramic material comprising molybdenum silicide (MoSi₂) in a volume percentage ranging from 2% to 40%,
silicon carbide (SiC)-based ceramic materials comprising molybdenum silicide in a volume percentage ranging from 20% to 40%,
aluminium nitride (AIN)-based ceramic materials containing additives and further containing a volume percentage of silicon carbide ranging from 5% to 25% and a volume percentage of molybdenum silicide ranging from 20% to 40%,
tantalum carbide (TaC)-based ceramic material comprising molybdenum silicide (M_{O}Si₂) in a volume percentage ranging from 2% to 40%,
the thermionic emitter (2) being made of a material selected from the group comprising or consisting of:
- thin film diamond of thickness lower than 25 micrometers deposited through chemical vapour deposition (CVD),
- thin film diamond of thickness lowerthan 25 micrometers deposited through CVD having a n-type doping,
- thin film diamond of thickness lowerthan 25 micrometers deposited through CVD having surface chemical termination with monoatomic hydrogen and/or depositions of zirconium and/or caesium,
- thin film diamond of thickness lowerthan 25 micrometers deposited through CVD having a n-type doping and having surface chemical termination with monoatomic hydrogen and/or depositions of zirconium and/or caesium,
- thin film ceramic materials of thickness lower than 25 micrometers selected from the group comprising or consisting of:
titanium nitride (TiN)-based ceramic materials,
molybdenum silicide-based ceramic materials,
carbide-based ceramic materials,
boride-based ceramic materials,
- refractory metals in thin film form with thickness not larger than 1 micrometer.

2. Converter device according to claim 1, **characterised in that** the absorber (1) is made of a ceramic material selected from the group comprising or consisting of:
hafnium carbide (HfC)-based ceramic material having a volume percentage of molybdenum silicide (MoSi₂) ranging from 2% to 30%, preferably ranging from 3% to 20%, more preferably ranging from 4% to 10%, still more preferably equal to 5%,
silicon carbide (SiC)-based ceramic material containing additives in a volume percentage lower than 20%, the additives comprising or consisting of aluminium oxide (Al₂O₃) and yttrium oxide (Y₂O₃), wherein the aluminium oxide is preferably ranging from 3% to 9% in volume, more preferably equal to 6% in volume, and wherein the yttrium oxide is preferably ranging from 1% to 7% in volume, more preferably equal to 4% in volume, and wherein the molybdenum silicide is present with a volume percentage preferably ranging from 25% to 35%, more preferably equal to 30%,
aluminium nitride (AIN)-based ceramic materials containing additives comprising yttrium oxide with a weight percentage ranging from 1% to 5%, preferably ranging from 1% to 3%, more preferably equal to 2%, and further containing a volume percentage of silicon carbide ranging from 5% to 25%, preferably ranging from 10% to 20%, more preferably equal to 15%, and a volume percentage of molybdenum silicide preferably ranging from 25% to 35%, more preferably equal to 30%,
tantalum carbide (TaC)-based ceramic material containing additives, preferably comprising aluminium oxide and/or yttrium oxide, and
molybdenum silicide with a volume percentage of molybdenum silicide preferably ranging from 25% to 35%, more preferably equal to 30%.

3. Converter device according to claim 1 or 2, **characterised in that** the thermionic emitter (2) is made of a material selected from the group comprising or consisting of:
- thin film diamond of thickness lower than 10 micrometers, preferably lower than 5 micrometers, more preferably lower than 1 micrometer, deposited through CVD,
- thin film diamond of thickness lower than 25 micrometers, preferably lower than 10 micrometers, more preferably lower than 5 micrometers, still more preferably lower than 1 micrometer, deposited through CVD having a n-type doping with nitrogen,
- thin film diamond of thickness lower than 10 micrometers, preferably lower than 5 micrometers, more preferably lower than 1 micrometer, deposited through CVD having surface chemical termination with monoatomic hydrogen and/or depositions of zirconium and/or caesium,
- thin film diamond of thickness lower than 25 micrometers, preferably lower than 10 micrometers, more preferably lower than 5 micrometers, still more preferably lower than 1 micrometer, deposited through CVD having a n-type doping with nitrogen and having surface chemical termination with monoatomic hydrogen and/or depositions of zirconium and/or caesium,
- titanium carbide (TiC)- and/or zirconium carbide (ZrC)- and/or tungsten carbide (WC)- and/or hafnium carbide (HfC)-based thin film ceramic materials of thickness lower than 25 micrometers,
- titanium boride (TiB₂)- and/or zirconium boride (ZrB₂)- and/or lanthanum hexaboride (LaB₆)-based thin film ceramic materials of thickness lower than 25 micrometers,
- thin film ceramic materials of thickness lower than 10 micrometers, preferably lower than 5 micrometers, more preferably lower than 1 micrometer, selected from the group comprising or consisting of:
titanium nitride (TiN)-based ceramic materials,
molybdenum silicide-based ceramic materials,
carbide-based ceramic materials,
boride-based ceramic materials,
- refractory metals in thin film form with thickness not larger than 1 micrometer, preferably not larger than 800 nanometers, more preferably not larger than 700 nanometers, still more preferably not larger than 600 nanometers, even more preferably not larger than 500 nanometers, even still more preferably not larger than 400 nanometers, selected from the group comprising or consisting of molybdenum and tungsten.

4. Converter device according to any one of the preceding claims, **characterised in that** the thermionic emitter (2) is separated from the thermionic collector (5) by a distance lower than 1 mm, preferably lower than 100 micrometers, more preferably lower than 10 micrometers, the thermionic emitter (2) being preferably separated from the thermionic collector (5) through one or more spacers (4; 112) more preferably made of a material selected from the group comprising or consisting of zirconia, alumina, and glass ceramic approximately composed of 55% fluorophlogopite mica and 45% borosilicate glass, the thermionic collector (5) being preferably made of a material selected from the group comprising or consisting of molybdenum and tungsten, more preferably coated with caesium.

5. Converter device according to any one of the preceding claims, **characterised in that** the absorber (1) is provided on one or more side walls with a layer of refractory metal, the absorber 1 having preferably a shape of a disc, more preferably having diameter ranging from 30 mm to 50 mm and thickness ranging from 3 mm to 10 mm.

6. Converter device according to any one of the preceding claims, **characterised in that** it further comprises a housing case (15; 100), wherein the absorber (1), the thermionic emitter (2) and the thermionic collector (5) are housed, the housing case (15; 100) being provided with a through hole closed by a window (101) configured to transmit electromagnetic radiation impinging on the same window to the outer surface (10) of the absorber (1), the housing case (15; 100) being configured to maintain vacuum conditions inside, preferably such that a pressure inside the housing case (15; 100) is lower than 10⁻⁵ mbar, said through hole being shaped according to a cone frustum with inner walls having an inclination with respect to a vertical axis of the cone frustum preferably equal to 45°, the converter device preferably further comprising a pumping apparatus connected through hydraulic connection means (201) to the housing case (15; 100), a distance between the window (101) and the outer surface (10) of the absorber (1) being preferably ranging from 1,0 mm to 10,0 mm, more preferably equal to 5,0 mm, the converter device preferably further comprising a front active heat sink (900) comprising at least one cavity provided with hydraulic connection means (909) configured to receive a flow of a cooling liquid for extracting heat from the window (101), the cooling liquid preferably comprising a solution of deionized water and ethylene glycol, more preferably in proportion 50%-50%, or demineralized water, an inner surface of the housing case (15; 100) being preferably coated with a layer of infrared reflecting material.

7. Converter device according to any one of the preceding claims, **characterised in that** it further comprises a thermoelectric module (115) comprising a first layer (6) configured to operate as hot side of the thermoelectric module (115), the first layer (6) being integrally coupled to a plurality of thermoelectric elements (7) provided with interconnecting tracks (70), the plurality of thermoelectric elements (7) being in turn integrally coupled to a second layer (8) configured to operate as cold side of the thermoelectric module (115), the thermionic collector (5) being integrally coupled to the first layer (6), the thermoelectric module (115) being provided with electrical connection means (116) configured to be connectable to a second external electrical load (75) for supplying electrical power to the latter, the first layer (6) and the second layer (8) being each preferably made of a ceramic material, more preferably diamond deposited through CVD or aluminium nitride deposited through screen printing or geopolimeric coating, the thermoelectric elements (7) being preferably selected from the group comprising semiconductor elements and pairs of elements made of metals with different work function, the thermoelectric elements (7) being more preferably made of a material selected from the group comprising or consisting of:
- a bismuth telluride (Bi₂Te₃) and antimony telluride (Sb₂Te)-based material,
- a lead telluride (PbTe)-based material,
- a silicon germanium (SiGe) alloy-based material,
- a doped barium and strontium titanate and/or lanthanate-based material,
- a carbides and/or borides-based material,
- a silicon carbide and/or silicon-silicon carbide-based material,
- a boron carbide-titanium boride (B₄C-TiB₂)-based material,
- a metal-ceramic composite material,
the thermoelectric elements (7) being still more preferably made of thin film lead telluride and n-type doped through antimony telluride and p-type doped through silver.

8. Converter device according to claim 7, **characterised in that** it further comprises back heat sinker means integrally coupled to the second layer (8) of the thermoelectric module (115) and configured to extract heat from the second layer (8) of the thermoelectric module (115), said heat sinker means being selected from the group consisting of:
- a back active heat sink (9) comprising at least one cavity provided with hydraulic connection means (90, 91) configured to receive a flow of a cooling liquid for thermostatically controlling the second layer (8) of the thermoelectric module (115), the cooling liquid preferably comprising a solution of deionized water and ethylene glycol, more preferably in proportion 50%-50%, or demineralized water,
- a passive heat exchanger.

9. Process of microfabrication of a converter device for converting energy from electromagnetic radiation, in particular concentrated solar energy, to electrical power, **characterised in that** the converter device is the converter device according to any one of claims 1 to 8, such a process comprising the steps of:
A. having the absorber (1),
B. depositing on said inner surface of the absorber (1) the material of which the thermionic emitter (2) is made, whereby at the end of step B the thermionic emitter (2) is monolithically integrated on said inner surface of the absorber (1),
C. making the sub-micrometer periodic surface structure by means of a treatment of the outer surface (10) of the absorber (1) through femto-second laser, whereby a laser beam directly impinges the outer surface (10) of the absorber (1).

10. Process according to claim 9, **characterised in that** step C is performed with:
- laser wavelength ranging from 200 to 1000 nanometers, preferably from 550 to 800 nanometers;
- duration of single laser pulse ranging from 10 to 100 femto-seconds;
- impingement of the laser beam with an angle with respect to a normal to the outer surface (10) of the absorber (1) ranging from 0° to 60°, preferably with impingement orthogonal to the outer surface (10) of the absorber (1), i.e. with an angle with respect to the normal to the outer surface (10) of the absorber (1) equal to 0°;
- laser pulse energy varying within the range 0,01 - 5,00 mJ/pulse, preferably within the range 0,2 - 2,0 mJ/pulse;
- spot focusing having diameter ranging from 5 µm to 1 mm, preferably ranging from 100 µm to 0,5 mm;
- speed of a translational plate on which the absorber (1) the outer surface (10) of which is treated under the laser beam is mounted varying within the range 0,01 - 100,00 cm/s, preferably within the range 0,2 - 3,0 cm/s.

11. Process according to claim 9 or 10, **characterised in that**, after step A, the following step is executed:
D. depositing a layer of refractory metal on one or more side walls of the absorber (1).

12. Process according to any one of claims 9 to 11, **characterised in that** step B comprises the following sub-step:
B.1 depositing diamond thin film of thickness lower than 25 micrometers on said inner surface of the absorber (1) through CVD, preferably through microwave CVD or through hot-filament CVD, having methane and hydrogen as precursor gases, the methane-to-hydrogen precursor gas ratio ranging from 0,05% to 5%, being preferably equal to 1%,
whereby the thermionic emitter (2) is made of a material selected from the group comprising or consisting of:
- thin film diamond of thickness lower than 25 micrometers deposited through CVD,
- thin film diamond of thickness lowerthan 25 micrometers deposited through CVD having a n-type doping,
- thin film diamond of thickness lowerthan 25 micrometers deposited through CVD having surface chemical termination with monoatomic hydrogen and/or depositions of zirconium and/or caesium,
- thin film diamond of thickness lowerthan 25 micrometers deposited through CVD having a n-type doping and having surface chemical termination with monoatomic hydrogen and/or depositions of zirconium and/or caesium,
wherein preferably sub-step B.1 is performed in a CVD reactor having an atmosphere in which a nitrogen gas is introduced, whereby the thermionic emitter (2) is preferably made of a material selected from the group comprising or consisting of:
- thin film diamond of thickness lowerthan 25 micrometers deposited through CVD having a n-type doping,
- thin film diamond of thickness lowerthan 25 micrometers deposited through CVD having a n-type doping and having surface chemical termination with monoatomic hydrogen and/or depositions of zirconium and/or caesium,
step B preferably further comprising, after sub-step B.1, the following sub-step:
B.2 exposing the diamond thin film obtained from step B.1. to hydrogen plasma so as to cause a hydrogen monoatomic layer to stick on a diamond surface,
whereby the thermionic emitter (2) is preferably made of a material selected from the group comprising or consisting of:
- thin film diamond of thickness lowerthan 25 micrometers deposited through CVD having surface chemical termination with monoatomic hydrogen and/or depositions of zirconium and/or caesium,
- thin film diamond of thickness lowerthan 25 micrometers deposited through CVD having a n-type doping and having surface chemical termination with monoatomic hydrogen and/or depositions of zirconium and/or caesium.

13. Process according to any one of claims 9 to 11, **characterised in that** step B comprises the following sub-step:
B.3 depositing lanthanum hexaboride (LaB₆) through physical vapour deposition (PVD), preferably followed by a treatment of a surface of the thermionic emitter (2) through femto-second laser, and/or through pulsed laser deposition (PLD), and/or through radio frequency cathodic sputtering (RF sputtering) technique on said inner surface of the absorber (1),
whereby the thermionic emitter (2) is made of lanthanum hexaboride (LaB₆), preferably nanostructurated, thin film of thickness lower than 25 micrometers, preferably not larger than 1 micrometer, more preferably not larger than 800 nanometers, still more preferably not larger than 700 nanometers, even more preferably not larger than 600 nanometers, even still more preferably not larger than 500 nanometers, still even more preferably not larger than 400 nanometers.

14. Process according to any one of claims 9 to 13, **characterised in that** it further comprises, after step C, the following step:
E. making on the thermionic collector (5) a first layer (6), configured to operate as hot side of a thermoelectric module (115), of a ceramic material selected between diamond deposited through CVD or aluminium nitride deposited through screen printing or geopolimeric coating,
whereby the converter device is the converter device according to claim 7.

15. Process according to claim 14, **characterised in that** it further comprises, after step E, the following step:
F. depositing selectively through PVD a plurality of thermoelectric elements (7) of electroconductive carbide and/or boride-based ceramic material on the first layer (6) obtained from step E,
or the following step:
G. depositing on the first layer (6) obtained from step E through PLD and/or through RF sputtering a lead telluride thin film at temperatures higher than 300 °C and lower than 700 °C, preferably ranging from 400°C to 550 °C, the lead telluride thin film being selectively n-type doped through a subsequent deposition of antimony telluride and being selectively p-type doped through subsequent deposition of silver, the lead telluride thin film being spatially defined according to an arrangement of thermoelectric elements (7), the deposition through PLD and/or through RF sputtering preferably comprising the following sub-steps:
G.1. depositing lead telluride starting from ablation of a monocrystalline or polycrystalline lead telluride target with purity of 99,995%,
G.2 performing an ablation of a antimony telluride target with purity of 99,995% for selectively introducing atoms of antimony into the lead telluride thin film obtained from sub-step G.1 and obtaining a n-type doping,
G.3 performing an ablation of a silver target with purity of 99,995% for selectively introducing atoms of silver and obtaining a p-type doping,
G.4 spatially defining the doped lead telluride thin film obtained from sub-steps G.1-G.3 through photolithographic techniques combined with chemical dissolution techniques for obtaining the arrangement of thermoelectric elements (7),
the process preferably further comprising, after step F or G, the following step:
H. making a second layer (8), configured to operate as cold side of the thermoelectric module (115), of a ceramic material selected between diamond deposited through CVD or aluminium nitride deposited through screen printing or geopolimeric coating.

## Patentansprüche

1. Umrichtervorrichtung zum Umwandeln von Energie aus elektromagnetischer Strahlung, insbesondere konzentrierter Sonnenenergie, in elektrische Energie, umfassend einen thermionischen Emitter (2), der durch einen Elektrodenzwischenraum (3) von einem thermionischen Kollektor (5) getrennt ist, wobei der thermionische Emitter (2) und der thermionische Kollektor (5) mit elektrischen Verbindungsmitteln (109, 110, 113, 114, 500) versehen sind, die so konfiguriert sind, dass sie an eine erste externe elektrische Last (30) zur Versorgung mit elektrischer Energie anschließbar sind, **dadurch gekennzeichnet, dass** sie ferner einen Absorber (1) elektromagnetischer Strahlung umfasst, konfiguriert, um elektromagnetische Strahlungsenergie in thermische Energie umzuwandeln, mit einer Außenfläche (10), die konfiguriert ist, um elektromagnetischer Strahlung ausgesetzt zu werden, und einer Innenfläche, die integral mit dem thermionischen Emitter (2) gekoppelt ist, wobei die Außenfläche (10) mit einer periodischen Oberflächenstruktur im Submikrometerbereich versehen ist, wobei der thermionische Emitter (2) monolithisch auf der Innenfläche des Absorbers (1) integriert ist, wobei der Absorber (1) aus einem Material hergestellt ist, das aus der Gruppe ausgewählt ist, die umfasst oder besteht aus:
- keramische Materialien, ausgewählt aus der Gruppe, die umfasst oder besteht aus:
keramisches material auf Hafniumcarbid-(HfC)-Basis, das Molybdänsilicid (MoSi2) in einem Volumenprozentsatz von 2% bis 40% umfasst,
keramische Materialien auf Siliciumcarbid-(SiC)-Basis, umfassend Molybdänsilicid in einem Volumenanteil im Bereich von 20% bis 40%,
keramische Materialien auf der Basis von Aluminiumnitrid (AIN), die Additive enthalten und ferner einen Volumenanteil an Siliziumkarbid im Bereich von 5 % bis 25 % und einen Volumenanteil an Molybdänsilizid im Bereich von 20 % bis 40 % enthalten,
Tantalkarbid (TaC)-basiertes Keramikmaterial, umfassend Molybdänsilicid (MoSi₂) in einem Volumenprozentsatz von 2% bis 40%,
wobei der thermionische Emitter (2) aus einem Material hergestellt ist, das aus der Gruppe ausgewählt ist, die umfasst oder bestehend aus:
- Dünnfilm-Diamant mit einer Dicke von weniger als 25 Mikrometern, der durch chemische Dampfabscheidung (CVD) abgeschieden wird,
- Dünnfilm-Diamant mit einer Dicke von weniger als 25 Mikrometern, der durch CVD mit einer Dotierung vom n-Typ abgeschieden wurde,
- Dünnfilm-Diamant mit einer Dicke von weniger als 25 Mikrometern, der durch CVD abgeschieden wurde und eine chemische Oberflächenverbindung mit monoatomarem Wasserstoff und/oder Abscheidungen von Zirkonium und/oder Cäsium aufweist,
- Dünnfilm-Diamant mit einer Dicke von weniger als 25 Mikrometern, der durch CVD abgeschieden wurde, mit einer Dotierung vom n-Typ und mit einer chemischen Oberflächen-Endverbindung mit monoatomarem Wasserstoff und/oder Ablagerungen von Zirkonium und/oder Cäsium,
- keramische Dünnschichtmaterialien mit einer Dicke von weniger als 25 Mikrometern, ausgewählt aus der Gruppe, die umfasst oder besteht aus:
Keramikmaterialien auf Titannitridbasis (TiN),
keramische Materialien auf Molybdänsilizidbasis,
keramische Materialien auf Karbidbasis,
keramische Materialien auf Boridbasis,
- Refraktärmetalle in Dünnschichtform mit einer Dicke von nicht mehr als 1 Mikrometer.

2. Umrichtervorrichtung nach Anspruch 1, **dadurch gekennzeichnet, dass** der Absorber (1) aus einem keramischen Material hergestellt ist, das aus der Gruppe ausgewählt ist, die umfasst oder besteht aus:
keramisches Material auf der Basis von Hafniumcarbid (HfC) mit einem Volumenprozentsatz an Molybdänsilicid (MoSi₂) im Bereich von 2% bis 30%, vorzugsweise im Bereich von 3% bis 20%, weiter vorzugsweise im Bereich von 4% bis 10%, noch bevorzugter gleich 5%,
Keramikmaterial auf Siliciumcarbid-(SiC)-Basis, das Additive in einem Volumenprozentsatz von weniger als 20% enthält, wobei die Additive Aluminiumoxid (Al₂O₃) und Yttriumoxid (Y₂O₃) umfassen oder aus diesen bestehen, wobei das Aluminiumoxid vorzugsweise von 3% bis 9% des Volumens, vorzugsweise von 6% des Volumens, und wobei das Yttriumoxid vorzugsweise von 1% bis 7% des Volumens, weiter vorzugsweise von 4% des Volumens, und wobei das Molybdänsilizid mit einem Volumenprozentsatz von vorzugsweise 25% bis 35%, weiter vorzugsweise von 30%, vorliegt,
Keramische Materialien auf der Basis von Aluminiumnitrid (AIN), die Additive enthalten, die Yttriumoxid mit einem Gewichtsprozentsatz im Bereich von 1% bis 5%, vorzugsweise im Bereich von 1% bis 3%, weiter vorzugsweise im Bereich von 2%, und ferner einen Volumenprozentsatz an Siliziumkarbid im Bereich von 5% bis 25%, vorzugsweise im Bereich von 10% bis 20%, vorzugsweise gleich 15%, und einen Volumenprozentsatz an Molybdänsilicid im Bereich von 25% bis 35%, vorzugsweise gleich 30%, enthalten,
Keramikmaterial auf Tantalkarbid-(TaC)-Basis, das Zusatzstoffe enthält, vorzugsweise Aluminiumoxid und/oder Yttriumoxid umfassend, und
Molybdänsilicid mit einem Volumenanteil an Molybdänsilicid, vorzugsweise im Bereich von 25% bis 35%, vorzugsweise gleich 30%.

3. Umrichtervorrichtung nach Anspruch 1 oder 2, **dadurch gekennzeichnet, dass** der thermionische Emitter (2) aus einem Material hergestellt ist, das aus der Gruppe ausgewählt ist, die umfasst oder besteht aus:
- Dünnfilm-Diamant mit einer Dicke von weniger als 10 Mikrometern, vorzugsweise weniger als 5 Mikrometern, mehr bevorzugt weniger als 1 Mikrometer, abgeschieden durch CVD,
- Dünnfilm-Diamant mit einer Dicke von weniger als 25 Mikrometern, vorzugsweise weniger als 10 Mikrometer, mehr bevorzugt weniger als 5 Mikrometer, noch mehr bevorzugt weniger als 1 Mikrometer, abgeschieden durch CVD mit einer n-Dotierung mit Stickstoff,
- Dünnfilm-Diamant mit einer Dicke von weniger als 10 Mikrometern, vorzugsweise weniger als 5 Mikrometern, mehr bevorzugt weniger als 1 Mikrometer, abgeschieden durch CVD mit oberflächenchemischer Endverbindung mit monoatomarem Wasserstoff und/oder Abscheidungen von Zirkonium und/oder Caesium,
- Dünnfilm-Diamant mit einer Dicke von weniger als 25 Mikrometern, vorzugsweise weniger als 10 Mikrometer, mehr bevorzugt weniger als 5 Mikrometer, noch bevorzugter weniger als 1 Mikrometer, abgeschieden durch CVD mit einer n-Dotierung mit Stickstoff und mit oberflächenchemischer Endverbindung mit monoatomarem Wasserstoff und/oder Abscheidungen von Zirkon und/oder Cäsium,
- Titancarbid (TiC)- und/oder Zirkoniumcarbid (ZrC)- und/oder Hartmetall (WC)- und/oder Hafniumcarbid (HfC)-basierte Dünnschichtkeramikmaterialien mit einer Dicke von weniger als 25 Mikrometern,
- Titanborid (TiB₂)- und/oder Zirkonborid (ZrB₂)- und/oder Lanthanhexaborid (LaB₆)-basierte Dünnschichtkeramikmaterialien mit einer Dicke von weniger als 25 Mikrometern,
- Dünnschichtkeramikmaterialien mit einer Dicke von weniger als 10 Mikrometern, vorzugsweise weniger als 5 Mikrometern, besser bevorzugt weniger als 1 Mikrometer, ausgewählt aus der Gruppe, die umfasst oder besteht aus:
Keramikmaterialien auf Titannitridbasis (TiN),
keramische Materialien auf Molybdänsilizidbasis,
keramische Materialien auf Karbidbasis,
keramische Materialien auf Boridbasis,
- Refraktärmetalle in Dünnschichtform mit einer Dicke von nicht mehr als 1 Mikrometer, vorzugsweise nicht mehr als 800 Nanometer, vorzugsweise nicht mehr als 700 Nanometer, noch mehr bevorzugt nicht mehr als 600 Nanometer, noch mehr bevorzugt nicht mehr als 500 Nanometer, noch mehr bevorzugt nicht mehr als 400 Nanometer, ausgewählt aus der Gruppe bestehend aus Molybdän und Wolfram.

4. Umrichtervorrichtung nach einem der vorstehenden Ansprüche, **dadurch gekennzeichnet, dass** der thermionische Emitter (2) vom thermionischen Kollektor (5) um einen Abstand von weniger als 1 mm, vorzugsweise weniger als 100 Mikrometer, vorzugsweise weniger als 10 Mikrometer getrennt ist, wobei der thermionische Emitter (2) vorzugsweise vom thermionischen Kollektor (5) durch einen oder mehrere Abstandshalter (4; 112) getrennt ist, weiter bevorzugt bestehend aus einem Material ausgewählt aus der Gruppe bestehend aus Zirkoniumdioxid, Aluminiumoxid und Glaskeramik, die etwa zu 55 % aus Fluorophlogopit-Glimmer und zu 45 % aus Borosilikatglas besteht, wobei der thermionische Kollektor (5) vorzugsweise aus einem Material ausgewählt aus der Gruppe bestehend aus Molybdän und Wolfram hergestellt ist, das vorzugsweise mit Cäsium beschichtet ist.

5. Umrichtervorrichtung nach einem der vorstehenden Ansprüche, **dadurch gekennzeichnet, dass** der Absorber (1) an einer oder mehreren Seitenwänden mit einer Schicht aus hochschmelzendem Metall versehen ist, wobei der Absorber (1) vorzugsweise eine Scheibenform aufweist, die einen Durchmesser von 30 mm bis 50 mm und eine Dicke von 3 mm bis 10 mm aufweist.

6. Umrichtervorrichtung nach einem der vorstehenden Ansprüche, **dadurch gekennzeichnet, dass** sie ferner ein Gehäuse (15; 100) umfasst, in dem der Absorber (1), der thermionische Emitter (2) und der thermionische Kollektor (5) untergebracht sind, wobei das Gehäuse (15; 100) mit einem Durchgangsloch versehen ist, das durch ein Fenster (101) verschlossen ist, das konfiguriert ist, um elektromagnetische Strahlung, die auf dasselbe Fenster trifft, auf die Außenfläche (10) des Absorbers (1) zu übertragen, wobei das Gehäuse (15; 100) konfiguriert ist, um die Vakuumbedingungen im Inneren aufrechtzuerhalten, vorzugsweise so, dass ein Druck im Inneren des Gehäuses (15; 100) niedriger als 10⁻⁵ mbar ist, wobei das Durchgangsloch gemäß einem Kegelstumpf geformt ist, wobei die Innenwände eine Neigung in Bezug auf eine vertikale Achse des Kegelstumpfes vorzugsweise gleich 45° aufweisen, wobei die Umrichtervorrichtung vorzugsweise ferner eine Pumpvorrichtung umfasst, die über hydraulische Verbindungsmittel (201) mit dem Gehäuse (15; 100) verbunden ist, wobei ein Abstand zwischen dem Fenster (101) und der Außenfläche (10) des Absorbers (1) vorzugsweise von 1,0 mm bis 10,0 mm, vorzugsweise gleich 5,0 mm, reicht, wobei die Konvertervorrichtung vorzugsweise weiterhin einen vorderen aktiven Kühlkörper (900) umfasst, der mindestens einen Hohlraum umfasst, der mit hydraulischen Verbindungsmitteln (909) versehen ist, die konfiguriert sind, um einen Strom einer Kühlflüssigkeit zum Entnehmen von Wärme aus dem Fenster (101) aufzunehmen, wobei die Kühlflüssigkeit vorzugsweise eine Lösung aus deionisiertem Wasser und Ethylenglykol, vorzugsweise im Verhältnis von 50%-50%, oder entmineralisiertem Wasser, eine Innenfläche des Gehäuses (15; 100) vorzugsweise mit einer Schicht aus infrarotreflektierendem Material beschichtet ist.

7. Umrichtervorrichtung nach einem der vorhergehenden Ansprüche, **dadurch gekennzeichnet, dass** sie ferner ein thermoelektrisches Modul (115) umfasst, das eine erste Schicht (6) umfasst, die konfiguriert ist, um als heiße Seite des thermoelektrischen Moduls (115) zu arbeiten, wobei die erste Schicht (6) integral mit einer Vielzahl von thermoelektrischen Elementen (7) gekoppelt ist, die mit Verbindungsbahnen (70) versehen sind, die Vielzahl von thermoelektrischen Elementen (7) wiederum integral mit einer zweiten Schicht (8) gekoppelt ist, die konfiguriert ist, um als Kaltseite des thermoelektrischen Moduls (115) zu arbeiten, wobei der thermionische Kollektor (5) integral mit der ersten Schicht (6) gekoppelt ist, wobei das thermoelektrische Modul (115) mit elektrischen Verbindungsmitteln (116) versehen ist, die konfiguriert sind, um mit einer zweiten externen elektrischen Last (75) verbunden werden zu können, um letztere mit elektrischer Energie zu versorgen, wobei die erste Schicht (6) und die zweite Schicht (8) jeweils vorzugsweise aus einem keramischen Material, vorzugsweise Diamant, der durch CVD oder Aluminiumnitrid, das durch Siebdruck oder geopolmerische Beschichtung abgeschieden wurde, abgeschieden ist, wobei die thermoelektrischen Elemente (7) vorzugsweise aus der Gruppe ausgewählt sind, die Halbleiterelemente und Paare von Elementen aus Metallen mit unterschiedlicher Arbeitsfunktion umfasst, wobei die thermoelektrischen Elemente (7) bevorzugter aus einem Material hergestellt sind, das aus der Gruppe ausgewählt ist, die umfasst oder besteht aus:
- ein auf Bismuttellurid (Bi₂Te₃) und Antimontellurid (Sb₂Te) basierendes Material,
- ein auf Blei-Tellurid (PbTe)-basiertes Material,
- ein auf Silizium-Germanium (SiGe)-Legierung basierendes Material,
- ein dotiertes Barium- und Strontiumtitanat- und/oder Lanthanatmaterial,
- einen Carbid- und/oder Borid-basierten Werkstoff,
ein Material auf Siliciumcarbid- und/oder Silicium-Siliciumcarbid-Basis,
- ein Borcarbid-Titanborid (B₄C-TiB₂)-basiertes Material,
- ein Metall-Keramik-Verbundwerkstoff,
wobei die thermoelektrischen Elemente (7) noch bevorzugter aus Dünnfilm-Bleitellurid hergestellt sind und n-Typ dotiert durch Antimontellurid und p-Typ dotiert durch Silber.

8. Umrichtervorrichtung nach Anspruch 7, **dadurch gekennzeichnet, dass** sie ferner Rückkühlmittel umfasst, die integral mit der zweiten Schicht (8) des thermoelektrischen Moduls (115) gekoppelt und konfiguriert sind, um Wärme aus der zweiten Schicht (8) des thermoelektrischen Moduls (115) zu entnehmen, wobei die Kühlmittel ausgewählt sind aus der Gruppe bestehend aus:
- einen rückwärtigen aktiven Kühlkörper (9), der mindestens einen Hohlraum umfasst, der mit hydraulischen Verbindungsmitteln (90, 91) versehen ist, die konfiguriert sind, um einen Strom einer Kühlflüssigkeit zum thermostatischen Steuern der zweiten Schicht (8) des thermoelektrischen Moduls (115) aufzunehmen, wobei die Kühlflüssigkeit vorzugsweise eine Lösung aus deionisiertem Wasser und Ethylenglykol, vorzugsweise im Verhältnis von 50%-50%, oder demineralisiertem Wasser umfasst,
- einem passiven Wärmetauscher.

9. Verfahren zur Mikrofertigung einer Umrichtervorrichtung zum Umwandeln von Energie aus elektromagnetische Strahlung, insbesondere konzentrierter Sonnenenergie, zu elektrischer Energie, **dadurch gekennzeichnet, dass** die Umrichtervorrichtung die Umrichtervorrichtung nach einem der Ansprüche 1 bis 8 ist, wobei ein solches Verfahren die folgenden Schritte umfasst:
A. Bereitstellen des Absorbers (1),
B. Abscheiden auf der Innenfläche des Absorbers (1) des Materials, aus dem der thermionische Emitter (2) hergestellt wird, wobei am Ende von Schritt B der thermionische Emitter (2) monolithisch auf der Innenfläche des Absorbers (1) integriert ist,
C. Herstellen der periodischen Oberflächenstruktur im Submikrometerbereich durch eine Behandlung der Außenfläche (10) des Absorbers (1) mittels Femtosekundenlaser, wobei ein Laserstrahl direkt auf die Außenfläche (10) des Absorbers (1) trifft.

10. Verfahren nach Anspruch 9, **dadurch gekennzeichnet, dass** Schritt C durchgeführt wird mit:
- Laserwellenlänge im Bereich von 200 bis 1000 Nanometer, vorzugsweise von 550 bis 800 Nanometer;
- Dauer des einzelnen Laserpulses im Bereich von 10 bis 100 Femtosekunden;
- Auftreffen des Laserstrahls mit einem Winkel in Bezug auf eine Normale zur äußeren Oberfläche (10) des Absorbers (1) im Bereich von 0° bis 60°, vorzugsweise Auftreffen orthogonal zur Außenfläche (10) des Absorbers (1), d.h. mit einem Winkel bezüglich der Normalen zur Außenfläche (10) des Absorbers (1) gleich 0°;
- Laserpulsenergie, die im Bereich von 0,01 - 5,00 mJ/Impuls variiert, vorzugsweise im Bereich von 0,2 - 2,0 mJ/Impuls;
- Spotfokussierung mit einem Durchmesser im Bereich von 5 um bis 1 mm, vorzugsweise im Bereich von 100 um bis 0,5 mm;
- Geschwindigkeit einer Translationsplatte, auf der der Absorber (1), dessen Außenfläche (10) unter dem Laserstrahl behandelt wird, montiert ist, variabel im Bereich von 0,01-100,00 cm/s, vorzugsweise im Bereich von 0,2 - 3,0 cm/s.

11. Verfahren nach Anspruch 9 oder 10, **dadurch gekennzeichnet, dass** nach Schritt A der folgende Schritt ausgeführt wird:
D. Abscheiden einer Schicht aus hochschmelzendem Metall auf einer oder mehreren Seitenwänden des Absorbers (1).

12. Verfahren nach einem der Ansprüche 9 bis 11, **dadurch gekennzeichnet, dass** Schritt B den folgenden Teilschritt umfasst:
B.1 Abscheiden einer dünnen Diamantschicht mit einer Dicke von weniger als 25 Mikrometern auf der Innenseite der Oberfläche des Absorbers (1) durch CVD, vorzugsweise durch Mikrowellen-CVD oder durch Heißfilament CVD, mit Methan und Wasserstoff als Vorläufergase, wobei das Methan-zu-Methan-CVD Wasserstoffvorläufergasanteil im Bereich von 0,05 % bis 5 %, vorzugsweise gleich 1 %,
wobei der thermionische Emitter (2) aus einem Material hergestellt ist, das aus der Gruppe ausgewählt ist, die umfasst oder besteht aus:
- Dünnfilm-Diamant mit einer Dicke von weniger als 25 Mikrometern, der durch CVD abgeschieden wird,
- Dünnfilm-Diamant mit einer Dicke von weniger als 25 Mikrometern, der durch CVD mit einer Dotierung vom n-Typ abgeschieden wurde,
- Dünnfilm-Diamant mit einer Dicke von weniger als 25 Mikrometern, der durch CVD abgeschieden wurde und eine chemische Oberflächenverbindung mit monoatomarem Wasserstoff und/oder Abscheidungen von Zirkonium und/oder Cäsium aufweist,
- Dünnfilm-Diamant mit einer Dicke von weniger als 25 Mikrometern, der durch CVD abgeschieden wurde, mit einer Dotierung vom n-Typ und mit einer chemischen Oberflächen-Endverbindung mit monoatomarem Wasserstoff und/oder Ablagerungen von Zirkonium und/oder Cäsium,
wobei vorzugsweise Teilschritt B.1 in einem CVD-Reaktor mit einer Atmosphäre durchgeführt wird, in die ein Stickstoffgas eingeleitet wird, wobei der thermionische Emitter (2) vorzugsweise aus einem Material hergestellt wird, das ausgewählt ist aus der Gruppe, die umfasst oder besteht aus:
- Dünnfilm-Diamant mit einer Dicke von weniger als 25 Mikrometern, der durch CVD mit einer Dotierung vom n-Typ abgeschieden wurde,
- Dünnfilm-Diamant mit einer Dicke von weniger als 25 Mikrometern, der durch CVD abgeschieden wurde, mit einer Dotierung vom n-Typ und mit einer chemischen Oberflächen-Endverbindung mit monoatomarem Wasserstoff und/oder Ablagerungen von Zirkonium und/oder Cäsium,
wobei Schritt B nach dem Teilschritt B.1 vorzugsweise den folgenden Teilschritt umfasst:
B.2 Aussetzen des aus Schritt B.1. erhaltenen Diamant-Dünnfilms gegenüber Wasserstoffplasma, um zu bewirken, dass eine monoatomare Wasserstoffschicht auf einer Diamantoberfläche haftet,
wobei der thermionische Emitter (2) vorzugsweise aus einem Material hergestellt ist, das ausgewählt ist aus der Gruppe, die umfasst oder besteht aus:
- Dünnfilm-Diamant mit einer Dicke von weniger als 25 Mikrometern, der durch CVD abgeschieden wurde und eine chemische Oberflächenverbindung mit monoatomarem Wasserstoff und/oder Abscheidungen von Zirkonium und/oder Cäsium aufweist,
- Dünnfilm-Diamant mit einer Dicke von weniger als 25 Mikrometern, der durch CVD abgeschieden wurde, mit einer Dotierung vom n-Typ und mit einer chemischen Oberflächen-Endverbindung mit monoatomarem Wasserstoff und/oder Ablagerungen von Zirkonium und/oder Cäsium.

13. Verfahren nach einem der Ansprüche 9 bis 11, **dadurch gekennzeichnet, dass** Schritt B den folgenden Teilschritt umfasst:
B.3 Abscheiden von Lanthanhexaborid (LaB₆) durch physikalische Dampfabscheidung (PVD), vorzugsweise gefolgt von einer Behandlung einer Oberfläche des thermionischen Emitter (2) durch Femtosekundenlaser und/oder durch gepulste Laserabscheidung (PLD) und/oder durch kathodisches Hochfrequenz-Sputtern (RF-Sputtern) auf der Innenfläche des Absorbers (1),
wobei der thermionische Emitter (2) aus Lanthanhexaborid (LaB₆), vorzugsweise nanostrukturiertem, dünnem Film mit einer Dicke von weniger als 25 Mikrometern, vorzugsweise nicht größer als 1 Mikrometer, bevorzugter nicht größer als 800 Nanometer, noch bevorzugter nicht größer als 700 Nanometer, noch bevorzugter nicht größer als 600 Nanometer, noch bevorzugter nicht größer als 500 Nanometer, noch bevorzugter noch nicht größer als 400 nanometer, hergestellt ist.

14. Verfahren nach einem der Ansprüche 9 bis 13, **dadurch gekennzeichnet, dass** es ferner nach Schritt C den folgenden Schritt umfasst:
E. Herstellen einer ersten Schicht (6) auf dem thermionischen Kollektor (5), die konfiguriert ist, um als heiße Seite eines thermoelektrischen Moduls (115) zu arbeiten, aus einem keramischen Material, ausgewählt zwischen Diamant, der durch CVD abgeschieden wird, oder Aluminiumnitrid, das durch Siebdruck oder geopolymere Beschichtung abgeschieden wird,
wobei die Konvertervorrichtung die Konvertervorrichtung nach Anspruch 7 ist.

15. Verfahren nach Anspruch 14, **dadurch gekennzeichnet, dass** es ferner nach Schritt E den folgenden Schritt umfasst:
F. selektives Abscheiden einer Vielzahl von thermoelektrischen Elementen (7) aus elektrisch leitfähigem Hartmetall und/oder Keramikmaterial auf Boridbasis auf der ersten Schicht (6), die aus Schritt E erhalten wurde, durch PVD,
oder den folgenden Schritt:
G. Abscheiden auf der ersten Schicht (6), die aus Schritt E durch PLD und/oder durch RF-Sputtern eines dünnen Bleitelluridfilms bei Temperaturen über 300 °C und unter 700 °C, vorzugsweise im Bereich von 400 °C bis 550 °C, erhalten wird, wobei der Lead-Tellurid-Dünnfilm selektiv n-dotiert durch eine nachfolgende Abscheidung von Antimontellurid und selektiv p-dotiert durch eine nachfolgende Abscheidung von Silber ist, wobei der Lead-Tellurid-Dünnfilm räumlich gemäß einer Anordnung von thermoelektrischen Elementen (7) definiert ist, wobei die Abscheidung durch PLD und/oder durch RF-Sputtern vorzugsweise die folgenden Teilschritte umfasst:
G.1. Abscheiden von Bleistellurid ausgehend von der Ablation eines mono- oder polykristallinen Bleistellurid-Targets mit einer Reinheit von 99,995%,
G.2 Durchführen einer Ablation eines Antimontellurid-Targets mit einer Reinheit von 99,995% zum selektiven Einbringen von Antimonatomen in den aus dem Teilschritt G.1 erhaltenen Bleistellurid-Dünnfilm und Erhalten einer Dotierung vom n-Typ,
G.3 Durchführen einer Ablation eines Silbertargets mit einer Reinheit von 99,995% zum selektiven Einbringen von Silberatomen und Erhalten einer p-Typ-Dotierung,
G.4 räumliches Definieren des dotierten Bleistellurid-Dünnfilms, der aus den Teilschritten G.1-G.3 durch photolithographische Techniken in Kombination mit chemischen Auflösungstechniken zum Erhalten der Anordnung thermoelektrischer Elemente (7) erhalten wird,
wobei das Verfahren vorzugsweise weiterhin nach Schritt F oder G den folgenden Schritt umfasst:
H. Herstellen einer zweiten Schicht (8), die konfiguriert ist, um als Kaltseite des thermoelektrischen Moduls (115) zu arbeiten, aus einem keramischen Material, ausgewählt aus Diamant, der durch CVD abgeschieden wurde, oder Aluminiumnitrid, das durch Siebdruck oder geopolymere Beschichtung abgeschieden wird.

## Revendications

1. Dispositif convertisseur pour convertir l'énergie d'un rayonnement électromagnétique, en particulier l'énergie solaire concentrée, en énergie électrique, comprenant un émetteur thermo-ionique (2) séparé par un espace inter-électrodes (3) d'un collecteur thermo-ionique (5), l'émetteur thermo-ionique (2) et le collecteur thermo-ionique (5) étant pourvus de moyens de connexion électrique (109, 110, 113, 114, 500) configurés pour pouvoir être connectés à une première charge électrique externe (30) pour fournir de l'énergie électrique, le dispositif convertisseur étant **caractérisé en ce qu'**il comprend en outre un absorbeur (1) de rayonnement électromagnétique, configuré pour transformer l'énergie de rayonnement électromagnétique en énergie thermique, ayant une surface externe (10) configurée pour être exposée à un rayonnement électromagnétique et une surface interne couplée intégralement à l'émetteur thermo-ionique (2), la surface externe (10) étant pourvue d'une structure de surface périodique sous-micrométrique, l'émetteur thermo-ionique (2) étant intégré de façon monolithique sur ladite surface interne de l'absorbeur (1), l'absorbeur (1) étant réalisé en un matériau choisi dans le groupe comprenant ou consistant en :
- des matériaux céramiques choisis dans le groupe comprenant ou consistant en :
un matériau céramique à base de carbure d'hafnium (HfC) comprenant du siliciure de molybdène (MoSi₂) dans un pourcentage en volume allant de 2% à 40%,
des matériaux céramiques à base de carbure de silicium (SiC) comprenant du siliciure de molybdène dans un pourcentage en volume allant de 20% à 40%,
des matériaux céramiques à base de nitrure d'aluminium (AIN) contenant des additifs et en outre contenant un pourcentage en volume de carbure de silicium allant de 5% à 25% et un pourcentage en volume de siliciure de molybdène allant de 20% à 40%,
un matériau céramique à base de carbure de tantale (TaC) comprenant du siliciure de molybdène (MoSi₂) dans un pourcentage en volume allant de 2% à 40%,
l'émetteur thermo-ionique (2) étant réalisé en un matériau choisi dans le groupe comprenant ou consistant en :
- du diamant sous forme de film mince d'épaisseur inférieure à 25 micromètres déposé par dépôt chimique en phase vapeur (CVD),
- du diamant sous forme de film mince d'épaisseur inférieure à 25 micromètres déposé par CVD ayant un dopage de type n,
- du diamant sous forme de film mince d'épaisseur inférieure à 25 micromètres déposé par CVD ayant une terminaison chimique de surface avec de l'hydrogène monoatomique et/ou des dépôts de zirconium et/ou de césium,
- du diamant sous forme de film mince d'épaisseur inférieure à 25 micromètres déposé par CVD ayant un dopage de type n et ayant une terminaison chimique de surface avec de l'hydrogène monoatomique et/ou des dépôts de zirconium et/ou de césium,
- des matériaux céramiques sous forme de film mince d'épaisseur inférieure à 25 micromètres choisis dans le groupe comprenant ou consistant en :
des matériaux céramiques à base de nitrure de titane (TiN),
des matériaux céramiques à base de siliciure de molybdène,
des matériaux céramiques à base de carbure,
des matériaux céramiques à base de borure,
- des métaux réfractaires sous forme de film mince d'épaisseur n'excédant pas 1 micromètre.

2. Dispositif convertisseur selon la revendication 1, **caractérisé en ce que** l'absorbeur (1) est réalisé en un matériau céramique choisi dans le groupe comprenant ou consistant en :
un matériau céramique à base de carbure d'hafnium (HfC) ayant un pourcentage en volume de siliciure de molybdène (MoSi₂) allant de 2% à 30%, de préférence allant de 3% à 20%, plus préférentiellement allant de 4% à 10%, et encore plus préférentiellement égal à 5%,
un matériau céramique à base de carbure de silicium (SiC) contenant des additifs dans un pourcentage en volume inférieur à 20%, les additifs comprenant ou étant constitués d'oxyde d'aluminium (Al₂O₃) et oxyde d'yttrium (Y₂O₃), où l'oxyde d'aluminium va de préférence de 3% à 9% en volume, plus préférentiellement est égal à 6% en volume, et où l'oxyde d'yttrium va de préférence de 1% à 7% en volume, plus préférentiellement est égal à 4% en volume, et où le siliciure de molybdène est présent avec un pourcentage en volume allant de préférence de 25% à 35%, plus préférentiellement égal à 30%,
des matériaux céramiques à base de nitrure d'aluminium (AIN) contenant des additifs comprenant de l'oxyde d'yttrium avec un pourcentage en poids allant de 1% à 5%, de préférence allant de 1% à 3%, plus préférentiellement égal à 2%, et en outre contenant un pourcentage en volume de carbure de silicium allant de 5% à 25%, de préférence allant de 10% à 20%, plus préférentiellement égal à 15%, et un pourcentage en volume de siliciure de molybdène de préférence allant de 25% à 35%, plus préférentiellement égal à 30%,
un matériau céramique à base de carbure de tantale (TaC) contenant des additifs, comprenant de préférence de l'oxyde d'aluminium et/ou de l'oxyde d'yttrium, et
du siliciure de molybdène avec un pourcentage en volume de siliciure de molybdène allant de préférence de 25% à 35%, plus préférentiellement égal à 30%.

3. Dispositif convertisseur selon la revendication 1 ou 2, **caractérisé en ce que** l'émetteur thermo-ionique (2) est constitué d'un matériau choisi dans le groupe comprenant ou consistant en :
- du diamant sous forme de film mince d'épaisseur inférieure à 10 micromètres, de préférence inférieure à 5 micromètres, plus préférentiellement inférieure à 1 micromètre, déposé par CVD,
- du diamant sous forme de film mince d'épaisseur inférieure à 25 micromètres, de préférence inférieure à 10 micromètres, plus préférentiellement inférieure à 5 micromètres, encore plus préférentiellement inférieure à 1 micromètre, déposé par CVD ayant un dopage de type n avec de l'azote,
- un film fin de diamant d'épaisseur inférieure à 10 micromètres, de préférence inférieur à 5 micromètres, de préférence inférieur à 1 micromètre, déposé par CVD ayant une terminaison chimique de surface avec de l'hydrogène monoatomique et/ou des dépôts de zirconium et/ou de césium,
- du diamant sous forme de film mince d'épaisseur inférieure à 25 micromètres, de préférence inférieure à 10 micromètres, plus préférentiellement inférieure à 5 micromètres, encore plus préférentiellement inférieure à 1 micromètre, déposé par CVD ayant un dopage de type n avec de l'azote et ayant une terminaison chimique de surface avec de l'hydrogène monoatomique et/ou des dépôts de zirconium et/ou de césium,
- un film mince de matériaux céramiques à base de carbure de titane (TiC) et/ou de carbure de zirconium (ZrC) et/ou de carbure de tungstène (WC) et/ou de carbure d'hafnium (HfC) d'épaisseur inférieure à 25 micromètres,
- un film mince de matériaux céramiques à base de borure de titane (TiB₂) et/ou de borure de zirconium (ZrB₂) et/ou d'hexaborure de lanthane (LaB₆) d'épaisseur inférieure à 25 micromètres,
- un film mince de matériaux céramiques d'épaisseur inférieure à 10 micromètres, de préférence inférieure à 5 micromètres, plus préférentiellement inférieure à 1 micromètre, choisi dans le groupe comprenant ou consistant en :
des matériaux céramiques à base de nitrure de titane (TiN),
des matériaux céramiques à base de siliciure de molybdène,
des matériaux céramiques à base de carbure,
des matériaux céramiques à base de borure,
- des métaux réfractaires sous forme de film mince d'épaisseur n'excédant pas 1 micromètre, de préférence n'excédant pas 800 nanomètres, plus préférentiellement n'excédant pas 700 nanomètres, plus préférentiellement encore n'excédant pas 600 nanomètres, de façon encore plus préférentielle n'excédant pas 500 nanomètres, et de façon encore davantage préférentielle n'excédant pas 400 nanomètres, choisis dans le groupe comprenant ou constitué de molybdène et de tungstène.

4. Dispositif convertisseur selon l'une quelconque des revendications précédentes, **caractérisé en ce que** l'émetteur thermo-ionique (2) est séparé du collecteur thermo-ionique (5) d'une distance inférieure à 1 mm, de préférence inférieure à 100 micromètres, encore plus préférentiellement inférieure à 10 micromètres, l'émetteur thermo-ionique (2) étant de préférence séparé du collecteur thermo-ionique (5) par une ou plusieurs entretoises (4; 112) plus préférentiellement réalisées en un matériau choisi dans le groupe comprenant ou constitué de zircone, d'alumine et de vitrocéramique composé approximativement de 55% de mica fluorophlogopite et 45% de verre borosilicate, le collecteur thermo-ionique (5) étant de préférence réalisé en un matériau choisi dans le groupe comprenant ou constitué de molybdène et de tungstène, plus préférentiellement revêtu de césium.

5. Dispositif convertisseur selon l'une quelconque des revendications précédentes, **caractérisé en ce que** l'absorbeur (1) est disposé sur une ou plusieurs parois latérales avec une couche de métal réfractaire, l'absorbeur (1) ayant de préférence la forme d'un disque, de préférence encore ayant un diamètre allant de 30 mm à 50 mm et une épaisseur allant de 3 mm à 10 mm.

6. Dispositif convertisseur selon l'une quelconque des revendications précédentes, **caractérisé en ce qu'**il comprend en outre un boîtier (15 ; 100), dans lequel l'absorbeur (1), l'émetteur thermo-ionique (2) et le collecteur thermo-ionique (5) sont logés, le boîtier (15 ; 100) étant pourvu d'un trou traversant fermé par une fenêtre (101) configuré pour transmettre un rayonnement électromagnétique frappant la même fenêtre à la surface externe (10) de l'absorbeur (1), le boîtier (15 ; 100) étant configuré pour maintenir des conditions de vide à l'intérieur, de préférence telles qu'une pression à l'intérieur du boîtier (15 ; 100) est inférieure à 10⁻⁵ mbar, ledit trou traversant étant conformé selon un tronc de cône avec des parois internes ayant une inclinaison par rapport à un axe vertical du tronc de cône de préférence égale à 45°, le dispositif convertisseur comprenant de préférence en outre un appareil de pompage relié par l'intermédiaire de moyens de raccordement hydraulique (201) au boîtier (15 ; 100), une distance entre la fenêtre (101) et la surface externe (10) de l'absorbeur (1) allant de préférence de 1,0 mm à 10,0 mm, plus préférentiellement étant égale à 5,0 mm, le dispositif convertisseur comprenant de préférence en outre un dissipateur thermique actif avant (900) comprenant au moins une cavité pourvue de moyens de raccordement hydraulique (909) configurés pour recevoir un écoulement d'un liquide de refroidissement pour extraire de la chaleur de la fenêtre (101), le liquide de refroidissement comprenant de préférence une solution d'eau déionisée et d'éthylène glycol, plus préférentiellement dans une proportion 50%-50%, ou de l'eau déminéralisée, une surface interne du boîtier (15 ; 100) étant de préférence revêtue d'une couche de matériau réfléchissant les infrarouges.

7. Dispositif convertisseur selon l'une quelconque des revendications précédentes, **caractérisé en ce qu'**il comprend en outre un module thermoélectrique (115) comprenant une première couche (6) configurée pour fonctionner en tant que côté chaud du module thermoélectrique (115), la première couche (6) étant couplée intégralement à une pluralité d'éléments thermoélectriques (7) dotés de pistes d'interconnexion (70), la pluralité d'éléments thermoélectriques (7) étant à son tour couplés intégralement à une seconde couche (8) configurée pour fonctionner en tant que côté froid du module thermoélectrique (115), le collecteur thermo-ionique (5) étant couplé intégralement à la première couche (6), le module thermoélectrique (115) étant pourvu de moyens de connexion électrique (116) configurés pour pouvoir être connectés à une deuxième charge électrique externe (75) pour fournir de l'énergie électrique à cette dernière, la première couche (6) et la seconde couche (8) étant chacune de préférence constituées d'un matériau céramique, de préférence du diamant déposé par CVD ou du nitrure d'aluminium déposé par sérigraphie ou revêtement géopolymérique, les éléments thermoélectriques (7) étant de préférence choisis dans le groupe comprenant des éléments semi-conducteurs et des paires d'éléments constitués de métaux ayant une fonction de travail différente, les éléments thermoélectriques (7) étant plus préférentiellement constitués d'un matériau choisi dans le groupe comprenant ou consistant en :
- un matériau à base de tellurure de bismuth (Bi₂Te₃) et de tellurure d'Antimoine (Sb₂Te),
- un matériau à base de tellurure de plomb (PbTe),
- un matériau à base d'alliage de silicium germanium (SiGe),
- un matériau à base de titanates et/ou lanthanates de baryum et de strontium dopés,
- un matériau à base de carbures et/ou de borures,
- un matériau à base de carbure de silicium et/ou de carbure de silicium-silicium,
- un matériau à base de borure de carbure de bore-titane (B₄C-TiB₂),
- un matériau composite métal-céramique,
les éléments thermoélectriques (7) étant encore plus préférentiellement constitués d'un film mince de tellurure de plomb et dopé de type n au moyen de tellurure d'antimoine et de type p dopé au moyen d'argent.

8. Dispositif convertisseur selon la revendication 7, **caractérisé en ce qu'**il comprend en outre des moyens de dissipation thermique arrière solidaires de la deuxième couche (8) du module thermoélectrique (115) et configurés pour extraire de la chaleur de la deuxième couche (8) du module thermoélectrique (115), lesdits moyens de dissipation thermique étant choisis dans le groupe constitué de :
- un dissipateur thermique actif arrière (9) comprenant au moins une cavité munie de moyens de connexion hydrauliques (90, 91) configurés pour recevoir un écoulement d'un liquide de refroidissement pour commander de manière thermostatique la seconde couche (8) du module thermoélectrique (115), le liquide de refroidissement comprenant de préférence une solution d'eau déionisée et d'éthylène glycol, plus préférentiellement en proportion 50%-50%, ou de l'eau déminéralisée,
- un échangeur de chaleur passif.

9. Procédé de microfabrication d'un dispositif convertisseur pour convertir l'énergie d'un rayonnement électromagnétique, en particulier l'énergie solaire concentrée, en énergie électrique, **caractérisé en ce que** le dispositif convertisseur est le dispositif convertisseur selon l'une quelconque des revendications 1 à 8, un tel procédé comprenant les étapes consistant à :
A. être pourvu de l'absorbeur (1),
B. déposer sur ladite surface interne de l'absorbeur (1) le matériau dont l'émetteur thermo-ionique (2) est fait, où à la fin de l'étape B, l'émetteur thermo-ionique (2) est intégré de façon monolithique sur ladite surface intérieure de l'absorbeur (1),
C. réaliser la structure de surface périodique sous-micrométrique au moyen d'un traitement de la surface extérieure (10) de l'absorbeur (1) par un laser femtoseconde, où le faisceau du laser frappe directement la surface extérieure (10) de l'absorbeur (1).

10. Procédé selon la revendication 9, **caractérisé en ce que** l'étape C est réalisé avec :
- une longueur d'onde laser allant de 200 à 1000 nanomètres, de préférence de 550 à 800 nanomètres ;
- une durée d'unique impulsion laser allant de 10 à 100 femtosecondes ;
- une incidence du faisceau laser avec un angle par rapport à une normale à la surface extérieure (10) de l'absorbeur (1) allant de 0° à 60°, de préférence avec une incidence orthogonale à la surface externe (10) de l'absorbeur (1), c'est-à-dire avec un angle par rapport à la normale à la surface externe (10) de l'absorbeur (1) égal à 0° ;
- une énergie d'impulsion laser variant dans la plage 0,01-5,00 mJ/impulsion, de préférence dans la plage 0,2-2,0 mJ/impulsion ;
- une mise au point ponctuelle d'un diamètre allant de 5 µm à 1 mm, de préférence allant de 100 µm à 0,5 mm ;
- une vitesse d'une plaque de translation sur laquelle l'absorbeur (1) dont la surface externe (10) est traitée sous le faisceau laser est monté variant dans la plage de 0,01 à 100,00 cm/s, de préférence dans la plage 0,2-3,0 cm/s.

11. Procédé selon la revendication 9 ou 10, **caractérisé en ce que**, après l'étape A, l'étape suivante est exécutée :
D. déposer une couche de métal réfractaire sur une ou plusieurs parois latérales de l'absorbeur (1).

12. Procédé selon l'une quelconque des revendications 9 à 11, **caractérisé en ce que** l'étape B comprend la sous-étape suivante :
B.1 déposer un film mince de diamant d'épaisseur inférieure à 25 micromètres sur ladite surface interne de l'absorbeur (1) par CVD, de préférence par CVD à micro-ondes ou par CVD à filament chaud, avec du méthane et de l'hydrogène en tant que gaz précurseurs, le rapport de gaz précurseur méthane sur hydrogène allant de 0,05% à 5%, étant de préférence égal à 1%,
où l'émetteur thermo-ionique (2) est réalisé en un matériau choisi dans le groupe comprenant ou consistant en :
- du diamant sous forme de film mince d'épaisseur inférieure à 25 micromètres déposé par CVD,
- du diamant sous forme de film mince d'épaisseur inférieure à 25 micromètres déposé par CVD ayant un dopage de type n,
- du diamant sous forme de film mince d'épaisseur inférieure à 25 micromètres déposé par CVD ayant une terminaison chimique de surface avec de l'hydrogène monoatomique et/ou des dépôts de zirconium et/ou de césium,
- du diamant sous forme de film mince d'épaisseur inférieure à 25 micromètres déposé par CVD ayant un dopage de type n et ayant une terminaison chimique de surface avec de l'hydrogène monoatomique et/ou des dépôts de zirconium et/ou de césium,
où de préférence, la sous-étape B.1 est réalisée dans un réacteur CVD ayant une atmosphère dans laquelle de l'azote gazeux est introduit, où l'émetteur thermo-ionique (2) est de préférence constitué d'un matériau choisi dans le groupe comprenant ou consistant en :
- du diamant sous forme de film mince d'épaisseur inférieure à 25 micromètres déposé par CVD ayant un dopage de type n,
- du diamant sous forme de film mince d'épaisseur inférieure à 25 micromètres déposé par CVD ayant un dopage de type n et ayant une terminaison chimique de surface avec de l'hydrogène monoatomique et/ou des dépôts de zirconium et/ou de césium,
l'étape B de préférence comprenant en outre, après la sous-étape B.1, une sous-étape suivante :
B.2 exposer le film mince de diamant obtenu à l'étape B.1 à du plasma d'hydrogène de façon à amener une couche monoatomique d'hydrogène à coller sur une surface de diamant,
où l'émetteur thermo-ionique (2) est de préférence constitué d'un matériau choisi dans le groupe comprenant ou consistant en :
- du diamant sous forme de film mince d'épaisseur inférieure à 25 micromètres déposé par CVD ayant une terminaison chimique de surface avec de l'hydrogène monoatomique et/ou des dépôts de zirconium et/ou de césium,
- du diamant sous forme de film mince d'épaisseur inférieure à 25 micromètres déposé par CVD ayant un dopage de type n et ayant une terminaison chimique de surface avec de l'hydrogène monoatomique et/ou des dépôts de zirconium et/ou de césium,

13. Procédé selon l'une quelconque des revendications 9 à 11, **caractérisé en ce que** l'étape B comprend la sous-étape suivante :
B.3 déposer de l'hexaborure de lanthane (LaB₆) par dépôt physique en phase Vapeur (PVD), de préférence suivi d'un traitement d'une surface de l'émetteur thermo-ionique (2) par laser femtoseconde, et/ou par dépôt par laser pulsé (PLD), et/ou par une technique de pulvérisation cathodique par radiofréquence (pulvérisation RF) sur ladite surface interne de l'absorbeur (1),
où l'émetteur thermo-ionique (2) est fait d'un film mince d'hexaborure de lanthane (LaB₆), de préférence nanostructuré, d'épaisseur inférieure à 25 micromètres, de préférence n'excédant pas 1 micromètre, plus préférentiellement encore n'excédant pas 800 nanomètres, de façon encore plus préférentielle n'excédant pas 700 nanomètres, de façon davantage préférentielle n'excédant pas 600 nanomètres, de façon encore plus préférentielle n'excédant pas 500 nanomètres, de façon encore davantage préférentielle n'excédant pas 400 nanomètres.

14. Procédé selon l'une quelconque des revendications 9 à 13, **caractérisé en ce qu'**il comprend en outre, après l'étape C, l'étape suivante :
E. réaliser sur le collecteur thermo-ionique (5) une première couche (6), configurée pour fonctionner en tant que côté chaud d'un module thermoélectrique (115), d'un matériau céramique choisi parmi le diamant déposé par CVD ou le nitrure d'aluminium déposé par sérigraphie ou revêtement géopolymérique,
où le dispositif convertisseur est le dispositif convertisseur selon la revendication 7.

15. Procédé selon la revendication 14, **caractérisé en ce qu'**il comprend en outre, après l'étape E, l'étape suivante :
F. déposer sélectivement par PVD une pluralité d'éléments thermoélectriques (7) de carbure électroconducteur et/ou de matériau céramique à base de borure sur la première couche (6) obtenue à partir de l'étape E,
ou l'étape suivante :
G. déposer sur la première couche (6) obtenue à partir de l'étape E par PLD et/ou par pulvérisation RF un film mince de tellurure de plomb à des températures supérieures à 300°C et inférieures à 700°C, de préférence allant de 400°C à 550°C, le film mince de tellurure de plomb étant sélectivement dopé de type n par un dépôt ultérieur de tellurure d'antimoine et étant sélectivement dopé de type p par dépôt ultérieur d'argent, le film mince de tellurure de plomb étant spatialement défini selon un agencement d'éléments thermoélectriques (7), le dépôt par PLD et/ou par pulvérisation RF comprenant de préférence les sous-étapes suivantes :
G.1. déposer du tellurure de plomb à partir de l'ablation d'une cible de tellurure de plomb monocristallin ou polycristallin avec une pureté de 99,995%,
G.2 réaliser une ablation d'une cible de tellurure d'antimoine avec une pureté de 99,995% pour introduire sélectivement des atomes d'antimoine dans le film mince de tellurure de plomb obtenu à partir de la sous-étape G.1 et obtenir un dopage de type n,
G.3 réaliser une ablation d'une cible d'argent avec une pureté de 99,995% pour introduire sélectivement des atomes d'argent et obtenir un dopage de type p,
G.4 définir spatialement le film mince de tellurure de plomb dopé obtenu à partir des sous-étapes G.1-G.3 au moyen de techniques photolithographiques combinées à des techniques de dissolution chimique pour obtenir l'agencement d'éléments thermoélectriques (7),
le procédé comprenant de préférence en outre, après l'étape F ou G, l'étape suivante :
H. réaliser une seconde couche (8), configurée pour fonctionner en tant que côté froid du module thermoélectrique (115), d'un matériau céramique choisi parmi le diamant déposé par CVD ou le nitrure d'aluminium déposé par sérigraphie ou revêtement géopolymérique.
